# EUROPEAN PATENT SPECIFICATION

(11) **EP 2 911 214 B1**
(45) Date of publication and mention of the grant of the patent: **08.08.2018**
(21) Application number: 15155880.6
(22) Date of filing: 20.02.2015
(51) Int. Cl.: H01L 51/52, H01L 51/05, H01L 27/28, H01L 27/32

(54) **Multilayer structure of an OLET transistor**
Mehrschichtige Struktur eines OLET-Transistors
Structure multicouche d'un transistor OLET

(30) Priority: 20.02.2014 IT BO20140082
(43) Date of publication of application: 26.08.2015
(73) Proprietor: Amorosi, Antonio, 40122 Bologna (IT)
(72) Inventor: Capelli, Raffaella, 40122 Bologna (IT)
(74) Representative: Ferrari, Barbara

(56) References cited:
- WO-A1-2013/017999
- WO-A1-2013/128344
- US-A1- 2013 175 518
- US-A1- 2014 043 307
- JUNG HWA SEO ET AL: "Solution-Processed Organic Light-Emitting Transistors Incorporating Conjugated Polyelectrolytes", ADVANCED FUNCTIONAL MATERIALS, WILEY - V C H VERLAG GMBH & CO. KGAA, DE, vol. 21, no. 19, 7 October 2011 (2011-10-07), pages 3667-3672, XP001571425, ISSN: 1616-301X, DOI: 10.1002/ADFM.201100682 [retrieved on 2011-07-18]
- SANTATO C ET AL: "Tetracene-based organic light-emitting transistors: optoelectronic properties and electron injection mechanism", SYNTHETIC METALS, ELSEVIER SEQUOIA, LAUSANNE, CH, vol. 146, no. 3, 3 November 2004 (2004-11-03), pages 329-334, XP004629451, ISSN: 0379-6779, DOI: 10.1016/J.SYNTHMET.2004.08.028
- Raffaella Capelli ET AL: "Organic light-emitting transistors with an efficiency that outperforms the equivalent light-emitting diodes", Nature Materials, vol. 9, no. 6, 1 June 2010 (2010-06-01), pages 496-503, XP055013298, ISSN: 1476-1122, DOI: 10.1038/nmat2751

## Description

### Field of application

The present invention refers to a multilayer structure of an OLET transistor.

More specifically the invention relates to a multilayer structure of an OLET transistor realized on at least one substrate, comprising at least one emissive organic layer and provided with a first and a second injection electrode and a control electrode.

The invention also refers to an elementary emissive unit or sub-pixel comprising, as emissive element, an OLET transistor and to a display comprising a matrix configuration of such elementary emissive units.

The invention relates, in particular but not exclusively, to a multilayer structure of an OLET transistor designed to form a viewing screen or display realized using organic technology, and the description below is provided with reference to this application sector with the sole aim of simplifying illustration thereof.

### Prior Art

As is well known, the current and well-established electronic and optoelectronic mass technology is essentially based on silicon, in particular monocrystalline silicon.

However, the possibility of using a similar technology based organic materials and referred to as organic electronics is arousing increasingly greater interest since it opens up hitherto unimaginable horizons in terms of applications.

These organic materials have in fact an important and interesting property which is intrinsically related to the physical properties of this particular class of materials, namely their plasticity.

Also of undeniable interest is the fact that organic materials may be easily found and may be processed using equipment and instruments which are much simpler and in particular less costly than those used hitherto in silicon technology.

The use of these organic materials would therefore allow the construction of wide-application electronic platforms with mechanical and portability properties which are entirely similar to a thin plastic sheet, in a technological scenario whose main advantages are the wide availability of the raw material and low production costs along with the limited environmental impact due to the intrinsic recyclability of the raw material being used.

In the context of organic electronics a sector which offers particularly interesting properties for the development of technologies requiring high degree of stability and reliability over time is so-called molecular electronics, involving, namely, the use of molecular materials produced by means of chemical synthesis processes. With these processes in fact it is possible to determine in a well-defined manner the chemical structure of the single oligomeric units which form the molecular materials, with undoubted advantages over the alternative technology of polymers, where the distribution of the lengths of the single chains which make up the polymer material can be only statistically determined; instead, advantageously, in the case of molecular materials the degree of reproducibility which can be obtained through a chemical synthesis process is intrinsically very high.

Furthermore, where molecular materials are used, the processes for purification of the raw synthesis product and the processes for analysis of the degree of purity of these molecular materials are much more effective and less costly than those required for polymer materials.

More particularly, once a basic organic product or raw product has been determined by means of a chemical synthesis process, the ensuing process step for manufacture of thin organic films having the physical properties necessary for the desired electronic application is of crucial importance in terms of the potential advantages of the technology.

It is well-known in fact that the possibility of being able to control almost entirely the atom crystal structure of the monocrystalline silicon wafers, or of the other materials used in electronic components, has been the determining factor which has allowed inorganic electronics to achieve the technological success which it enjoys today, despite very high production costs.

Precisely in order to reduce these production costs, inorganic technologies which offer an alternative to monocrystalline silicon, in particular technologies based on amorphous or polycrystalline silicon, have been recently developed. This approach, however, has resulted in less control over the microstructure of the thin film obtained with these alternative materials and, consequently, has given rise to problems associated with the reproducibility and stability over time of the electronic devices thus obtained.

It is quite clear that an electronics technology based on molecular materials offers a unique opportunity to combine low production costs with a high degree of control over the microstructure of the thin organic films obtained from them and, consequently, their physical properties. In particular, this control is excellent when the manufacture of the thin films is carried out by means of a molecular beam deposition process. In this case, in fact, the correlation between the process parameters (such as the evaporation rate, the temperature of the substrate, the voltage and the surface energy of the substrate, the pressure and the chemical composition of the deposition chamber) and molecular packing of the film obtained may be refined to a very high level.

This thus opens up the possibility of developing a technology which could become competitive with inorganic technology in terms of performance reliability, while ensuring low manufacturing costs.

Despite the enormous potential, the presence of organic electronics in the world market is however limited at present to the implementation of organic/inorganic hybrid devices, in particular viewing screens or displays.

More particularly, the latest generation of mobile phones or smart phones comprise OLEDs (Organic Light Emitting Diodes) as emissive elements for the screen, all the remaining electronic driving elements of the screen however being still produced using conventional inorganic electronics technology, based on monocrystalline silicon and/or amorphous or polycrystalline silicon.

This type of screen is in fact typically driven by means of a so-called active matrix and is usually referred to as an AMOLED (Active Matrix Organic Light Emitting Diode) screen.

At present the main obstacle preventing a complete transition from the inorganic approach to the organic approach is the performance of the organic devices which is intrinsically and substantially inferior to that of inorganic devices.

In the specific case of an AMOLED screen, for example, the emissive element, although it is organic, requires high supply currents which cannot be obtained from organic transistors such as those which are currently available. For this reason, in order to reduce the manufacturing costs and ensure compatibility with the flexible or glass-to-glass platforms which are currently used, driving transistors based on amorphous or polycrystalline silicon are used in an AMOLED device.

The use of OLED diodes, as emissive elements, and transistors based on amorphous or polycrystalline silicon, however, results in an end device which is affected by significant problems associated with the reproducibility and stability over time of the single elements. In particular a matrix of OLED diodes which are nominally the same and drive at the same potential gives rise, in reality, to a somewhat non-uniform pixel distribution in terms of light intensity emitted.

Similarly, an array of amorphous or polycrystalline silicon transistors, in particular the widely used TFTs (Thin Film Transistors), which are nominally the same and driven in the same manner, in reality produces a non-uniform distribution of currents supplied. Furthermore, the characteristics of the single device, both of the OLED type and amorphous or polycrystalline TFT type, substantially change depending on the operating time of the device, essentially due to the limited control of the manufacturing process.

It is therefore known that these AMOLED screens or displays require particular driving methods and therefore control circuits which necessarily complicate the overall architecture, as described for example in US Patent No. US 5,952,789 granted on 14 September 1999 in the name of Stewart et al. (Sarnoff Corporation, Princeton, N. J.) and in the minutes of the 9th Symposium of Information Display (8-12 October 2006, New Delhi, India) in the name of Min-Koo Han.

AMOLED displays are therefore still very complex hybrid organic/inorganic devices which are unable to make use of all the possible technological advantages of a completely molecular approach.

An optoelectronic light-emitting device which is also known is an OLET (Organic Light-Emitting Transistor).

Theoretically an OLET transistor could incorporate in it the functions which in AMOLED screens are nowadays performed by the combination of an OLED diode and its current supply transistor present in the active matrix.

On the one hand, in fact, compared to a diode, a transistor is intrinsically characterized by a charge transport geometry which could avoid the well-known problems of micro short-circuits which are typical of OLED diodes. In a transistor, in fact, the charges move parallel to the substrate of the transistor, along distances of several micrometres between the charge injection (drain-source) electrodes which are arranged in parallel with each other, without the need to manage vertical configurations as in the case of OLED diodes. The gate electrode is moreover separated from the drain and source electrodes by an insulating layer and the local electric fields are various orders of magnitude smaller in the OLET transistors than those present in OLED diodes, reducing the probability of short-circuiting occurring between the electrodes, for the same control over the defects present in the thin organic film thus formed.

Moreover, particular advantages could be achieved using OTFT (Organic Thin Film Transistor) technology.

Basically, using OLET emissive sources, a degree of reliability and stability over time which is much greater than that of the solutions comprising OLED diodes may be expected.

Moreover, the process control which can be obtained in molecular transistors, such as OLETs, may ensure a reproducibility and a stability over time which greater than that possible for amorphous or polycrystalline inorganic TFT transistors. In particular, by being able to control to a desired level the uniformity and stability over time of the OLET transistors and also of the organic thin film transistors (OTFT), in principle it is therefore possible to imagine essential architectures suitable for forming organic screens or displays which do not require performance control and stabilization devices.

OLET transistors are devices which are known and widely researched, as described for example in the international (PCT) patent application published under No. WO 20131/28344 in the name of the Applicants and in US patent application published under No. US 2012/0319093 in the name of Muccini et al.. The research carried out in the area of OLET technology is principally aimed at a maximizing the external quantum efficiency (EQE) of the device, namely the number of photons emitted per number of charges circulating in the transistor and/or the extension of the emissive area, by means of architecture which does not necessarily involve MOSFET type operation. In particular, the mentioned documents describe OLET platforms with ambipolar operation, namely MOSFET transistors which may operate with both types of carriers (p-channel or n-channel). These ambipolar transistors, however, have current/voltage response characteristics which are completely different from those of a MOSFET transistor. In order to perform an optimum integration of an OLET transistor inside a digital circuit, such as a display, the MOSFET behaviour, however, becomes a necessary condition.

U.S. patent application published under No. US 2013/175518 relates to an electroluminescent organic transistor or OLET, which comprises a semiconductor heterojunction including a plurality of layers of the p type and of the n type, the multilayer structure being characterized by alternating of layers of FET type, which carry holes and electrons, separated by an emissive layer and working in ambipolar condition.

Moreover, PCT patent application published under No. WO 2013/128344 relates to a three-layer structure to realize a light emitting transistor of ambipolar type and the conditions that has to be fulfilled in order to obtain an OLET device showing a light emission from the device channel.

Finally, PCT patent application published under No. WO 2013/017999 discloses an ambipolar device and explains how it is possible to use an additional gate electrode to activate and emphasize the FET charge transport within the second semiconductor layer of the three layers heterojunction, in order to balance the number of holes and electrons circulating inside the device channel, even when the charge mobility of the two layers are very different between one another.

The key element for being to perform this technological leap is, as mentioned, an OLET transistor able to combine the operating modes of a MOSFET transistor with the generation of electroluminescence in conjunction and in line with the passage of current so as to provide a light source with characteristics typical of a conventional MOSFET transistor.

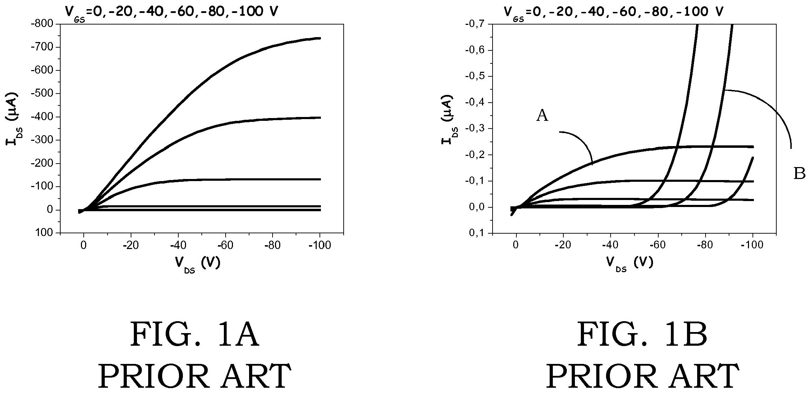

In particular, according to the classic MOSFET response, for all the gate voltage values lying below a threshold value (value which depends on the materials used for manufacture of the transistor), the current flowing in the transistor is negligible for any drain-source voltage value applied (sub-threshold value) in the so-called OFF state of the transistor. On the other hand, for each given gate voltage value above the threshold value, the current reaches a constant plateau which does not vary with an increase in the potential applied between drain and source (saturation condition), in the so-called ON state of the transistor, as shown in Figure 1A, which shows the pattern of the current I_{DS} which passes through a MOSFET transistor as a function of the drain-source voltage V_{DS} upon variation of the gate voltage V_{GS}.

On the other hand, in the case of ambipolar transistors, there does not exist an actual OFF state of the transistor and, even for a zero value of the gate voltage, there is always a significant passage of current. In the same way there is not an actual ON state of the transistor since there is no saturation of the current. Rather, the current continues to increase in a manner not linear with the increase in the potential applied between drain and source, as shown in Figure 1B, which shows the pattern of the current I_{DS} which passes through an ambipolar transistor as a function of the drain-source voltage V_{DS} upon variation of the gate voltage V_{GS}, the curves A referring to the transport of majority carriers and the curves B referring to the transport of minority carriers.

It is thus possible to establish that, although an ambipolar OLET transistor is preferable from the point of efficiency or amplitude of the emissive area, its electrical behaviour is inappropriate for a correct use within a digital electronic circuit, being passed through by a current does not saturate and is not even zero when no gate voltage is applied, due to the transport of the minority carriers.

The technical problem of the present invention is that of devising an integrated structure of an OLET transistor able to provide an emissive source with a high brightness and efficiency performance, while maintaining a unipolar electrical behaviour of the MOSFET type, having structural and functional characteristics such that it is possible to overcome the limitations and drawbacks which hitherto affect the organic transistors designed according to the prior art.

### Summary of the invention

The idea of solution at the basis of the present invention is that of using a multilayer organic structure comprising a single field-effect transport layer, of the p-type or n-type irrespectively, a light-generating or emissive layer and a layer with negligible field-effect transport properties, having the function of blocking the majority charge carriers from the transport layer and favouring the bulk transport of the minority charge carriers inside the emissive layer.

On the basis of this solution of solution the technical problem is solved by at multilayer structure of an OLET transistor realized on at least one substrate, comprising at least one emissive organic layer and provided with a first and a second injection electrode and with a control electrode, characterized by comprising at least one organic active region composed of a sequence of three organic layers:
- a first organic layer having field-effect transport properties;
- said emissive organic layer, and
- a second organic layer having the function of blocking the majority charge carriers from said first organic layer, said emissive organic layer being sandwiched between said first and second organic layers, as well as
at least one dielectric layer which separates said control electrode from said organic active region and is in contact with said first organic layer, said first injection electrode being in contact with said second organic layer, wherein
said second organic layer is made from an organic material with the following characteristics:
a) it has an energy distribution with respect to said emissive organic layer capable of blocking the diffusion of the majority charge carriers from said first organic layer, by generating, at the interface between said emissive organic layer and said second organic layer, an energy barrier during the passage from the emissive organic layer to the second organic layer greater than or equal to 0.1 eV for the majority charge carriers where the term "energy barrier" is understood as meaning the absolute value of the difference between the LUMO (Lowest Occupied Molecular Orbital) levels or HOMO (Highest Occupied Molecular Orbital) levels of the materials forming said interface and as further defined in claim 1;
b) it has a charge mobility which is at least two orders of magnitude less than that of the majority charge carriers of the first organic layer, the mobility of the first organic layer being measured on an OTFT transistor based solely on the first organic layer, while the mobility of the second organic layer is measured for the majority charge carriers on an OTFT transistor based solely on such organic material forming the second organic layer and for the minority charge carriers on an OTFT transistor comprising the three-layer configuration of the organic active region having a dielectric layer in contact with said first organic layer and injection electrodes in contact with said second organic layer; and
c) it favours the bulk transport of the minority charge carriers compared to the majority charge carriers from said first injection electrode to the interface with said emissive organic layer by having a volume mobility of the minority carriers at least one order of magnitude greater than the volume mobility of the majority carriers, said interface being separated from said first injection electrode by a distance of at least 10 nm.

More particularly, the invention comprises the following additional and optional features, considered individually or if necessary in combination.

According to another aspect of the invention, the aforementioned organic material which forms the second organic layer may have bulk transport and mobility properties greater than or equal to 10⁻⁸ cm²/Vs, for the minority charge carriers, the mobility being understood as being measured on a structure of the diode type with a characterization of the time-of-flight or SCLC type for the second organic layer in the form of a thin film.

The aforementioned organic materials which form the first organic layer, the emissive organic layer and the second organic layer of the present invention form energy barriers at their interfaces chosen as follows:
- an energy barrier at the interface between the first organic layer and the emissive organic layer less than or equal to 0.6 eV for the majority charge carriers;
- an energy barrier during the passage from the emissive organic layer to the first organic layer equal to or greater than 0 eV for the minority charge carriers; and
- an energy barrier during the passage from the second organic layer to the emissive organic layer less than or equal to 1.5 eV for the minority charge carriers.

According to another aspect of the invention, the aforementioned photoluminescent material which forms the emissive organic layer may have quantum yield (QY) photoluminescence values greater than 10% and is chosen so as to have a photoluminescence spectrum centred on one of the three colour coordinates RGB, in accordance with the PAL or NTSC standard.

The photoluminescent material which forms said emissive organic layer may also allow a bulk transport with a mobility being preferably greater than or equal to 10⁻⁸ cm²/Vs, for both the majority and minority charge carriers, mobility being understood as measured on a structure of the diode type with characterization of the time-of-flight or SCLC type for an emissive organic layer in the form of a thin film.

The aforementioned emissive organic layer may be formed by a system of the host-guest type with a triplet emission.

According to another aspect of the invention the aforementioned emissive organic layer may be made of a mixture of several materials.

Furthermore, the aforementioned emissive organic layer may comprise a stack of two or more layers and at least one of these layers may be made of a mixture of several materials.

According to another aspect of the invention, the first organic layer may be made with an organic material having a charge mobility greater than or equal to 10⁻² cm²/Vs, the charge mobility being calculated by carrying out measurements on an organic thin film transistor OTFT, optimized on the basis only of this material and using the electrical characterization of standard MOSFET transistors.

Moreover, the aforementioned first organic layer may be made of a molecular material, in particular chosen from the oligomeric classes of thiophene derivatives, acene derivatives, perfluoroacene derivatives, perylene derivatives, derivatives of fluoroarenes, derivatives of thiophene-fluorarenes, benzo[1,2-b:4,5-b']dichalcogenophenes (BDXs), [1]benzochalcogenopheno-[3,2-b][1]benzochalcogenophenes (BXBXs), dinaphtho[2,3-b:2',3'-f]-chalcogenopheno[3,2-b]chalcogenophenes (DNXXs), or more preferably 2,7-dioctyl[1]benzothieno[3,2-b][1]benzothiophene (C8-BTBT), N,N'-ditridecylperylene-3,4,9,10-tetracarboxylic Diimide (P13), Pentacene, Dinaphtho[2,3-b:2',3'-f]thieno[3,2-b]thiophene (DNTT), 1,3,6,8(2H,7H)-Tetraone, 2,7-dicyclohexylbenzo[lmn][3,8]phenanthroline.

Furthermore, the aforementioned dielectric layer may prevent the passage of current through it for a value of at least 10³ times, preferably for a value greater than or equal to 10⁵ times, the passage of current between the injection electrodes.

The aforementioned dielectric layer may be made of one of the the following materials: organic materials, such as PMMA (polymethylmethacrylate) with dielectric constant which is very low or equal to about 3.6, Su8 P(VDF-TrFE-CFE) or a polymer dielectric with relative dielectric constant greater than 30, preferably equal to about 50, metal oxides, such as zirconium oxide, hafnium oxide, aluminium oxide, or organic/inorganic hybrid nano-composites in order to obtain dielectric films with optimum optical transparency properties.

According to another aspect of the invention, the first and the second injection electrodes and the control electrode may be made of a material chosen from among: metals, such Au, Ag, Al, Cu, Ca, Pt, conductive oxides, such as ITO, or conductive organic films, such as graphene.

According to another aspect of the invention, the aforementioned multilayer structure of an OLET transistor may also comprise a glass substrate on which a layer of ITO is placed with the function of control electrode, a dielectric layer of PMMA and said organic active region, in turn comprising a first organic layer of C8-BTBT, i.e. 2,7-dioctyl[1]benzothieno[3,2-b][1]benzothiophene, and a second organic layer of 2,5-bis [4- (heptadecafluorooctyl) phenyl] thieno [3,2 -b] thiophene which enclose an emissive organic layer formed by a system comprising CBP matrix, namely 4,4'-Bis(N-carbazolyl)-1,1'-biphenyl), in which an emissive dye of IrPiq₃, i.e. Tris[1-phenylisoquinoline-C2,N]iridium(III), is dispersed, and gold injection electrodes formed on the second organic layer of the organic active region and in which such C8-BTBT which forms the first organic layer has the following formula: 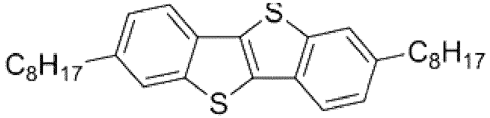 the 2,5-bis[4-(heptadecafluorooctyl)pnenyl]thieno[3,2-b]thiophene which forms the second organic layer has the following formula: 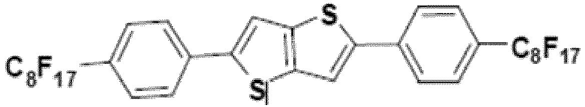 and the components of the CBP:Irpiq₃ system which forms the emissive organic layer have the following formula:

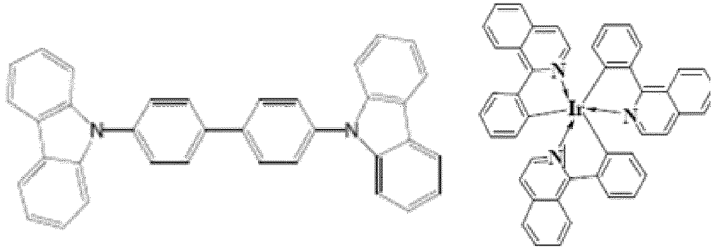

In particular, the injection electrodes may be made of silver and the emissive organic layer may comprise as host matrix a derivative of said CBP terminated with branched alkyl chains and having the formula:

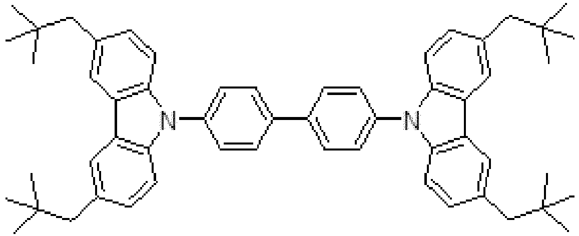

The control electrode may also be made with a sheet of graphene which is about 5 nm thick, conductive, transparent, organic and completely flexible.

The problem is also solved by an elementary emissive unit or sub-pixel characterized by comprising as emissive element an OLET transistor realized by means of a multilayer structure of the abovementioned type.

According to another aspect of the invention, the OLET transistor may be coupled, by means of its injection electrodes, between a first supply voltage reference and a second ground voltage reference and the unit may further comprise at least one addressing and control transistor having at least one of the injection electrodes connected to a control electrode of the OLET transistor and a control electrode connected to a first selection line.

According to another aspect of the invention, the addressing and control transistor may be coupled via its injection electrodes, between the control terminal of the OLET transistor and a data line.

Furthermore, the aforementioned elementary emissive unit or sub-pixel may be further connected to a transistor common to an entire row or column of elementary emissive units or sub-pixels, coupled by means of its injection electrodes, between a data voltage reference and the data line of each elementary emissive unit or sub-pixel and having a gate terminal connected to a second selection line.

The aforementioned elementary emissive unit or sub-pixel may also comprise a first and a second addressing and control transistor, respectively, electrically connected to each other via one of the injection electrodes in a common terminal, the first addressing and control transistor being coupled between the data line and the common terminal and having a control electrode connected to a first selection line, while the second addressing and control transistor is coupled between the gate electrode of the OLET transistor and the common terminal and has a control electrode connected to a second selection line.

The addressing and control transistors may be thin film organic transistors OTFTs.

According to another aspect of the invention, the OLET transistor may comprise an integrated intrinsic capacitor having, as plates, one of said injection electrodes and said control electrode and, as insulating region, a portion of a dielectric layer which separates said control electrode from an organic active region, this intrinsic capacitor being able to store a status of the pixel which is realized by the aforementioned OLET transistor.

Finally, the technical problem is solved by a display comprising a matrix configuration of elementary emissive units of the type described above.

The features and advantages of the multilayer structure, emissive unit and display according to the invention will emerge from the description, provided hereinbelow, of a non-limiting example of embodiment thereof with reference to the accompanying drawings.

### Brief description of the drawings

In these drawings:
- Figures 1A and 1B show the I-V characteristics of a conventional MOSFET transistor and an ambipolar transistor which have been realized according to the prior art;
- Figures 2A and 2B show a first and a second embodiment of a multilayer structure of an OLET organic transistor realized according to the invention;
- Figures 3A and 3B show, on a larger scale, a detail of the multilayer structure shown in Figures 2A and 2B;
- Figures 4A-4D show the structure and characteristic patterns of a preferred embodiment of the multilayer structure according to Figure 2A; and
- Figures 5A and 5B show architectures comprising an OLET transistor realized by means of the multilayer structure of Figures 2A and 2B as emissive element.

### Detailed description

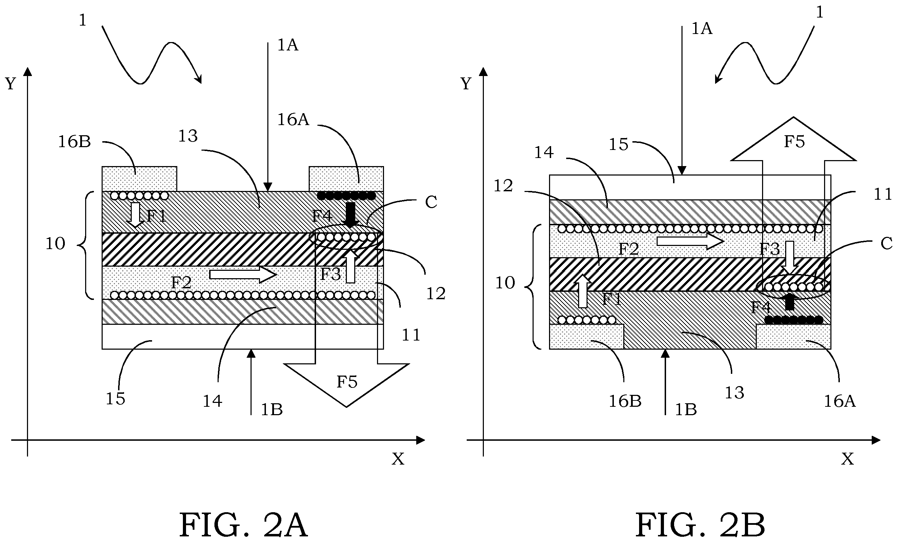

With reference to these figures, and in particular to Figures 2A and 2B, a multilayer structure of a transistor, in particular an OLET organic transistor, is generally and schematically indicated with 1.

It should be pointed out that the figures are schematic views of the multilayer structure and are not drawn to scale, but are instead drafted so as to emphasize the main features of the invention.

The multilayer structure 1 comprises essentially an organic reactive region 10 composed of a sequence of three organic layers, in particular a first organic layer 11 having field-effect transport properties (field-effect transport layer) and a second organic layer 13 having the function of blocking charges (charge blocking layer), these layers having sandwiched between them an emissive organic layer 12 (light-emitting layer).

The multilayer structure 1 further comprises at least one dielectric layer 14 which separates the gate electrode 15 from the organic active region 10 and is in contact with the first organic layer 11 and at least one drain electrode 16A in contact with the second organic layer 13. Optionally, a source electrode 16B may also be in contact with the second organic layer 13.

More particularly, the multi-layer structure 1 shown in Figure 2A is adapt to form an OLET transistor in a bottom gate and top contact (BG-TC) configuration, where the drain and source electrodes, 16A and 16B, are situated on a first side or top side 1A of the multilayer structure 1, where the gate electrode 15 is formed on a second side or rear side 1B, in the direction of the vertical extension Y of the multilayer structure 1 shown in the figures.

Figure 2B shows a reverse configuration, namely a multilayer structure 1 apt to form an OLET transistor in a top gate and bottom contact (TG-BC) configuration, where the gate electrode 15 is formed on the top side 1A and the drain and source electrodes 16A and 16B are arranged on the bottom side 1B.

The choice of configuration is substantially of no importance and may be optimized depending on the process for the complete realization of an end device comprising these OLET transistors, for example an emissive screen or display.

The dielectric layer 14 may be a conventional gate dielectric of a MOSFET transistor and is substantially the insulating layer of the OLET transistor realized by the multilayer structure 1.

For correct operation of the multilayer structure 1 as an emissive layer, the second organic layer 13 is chosen so as to prevent the charges from the first organic layer 11 from being able to easily pass through from the emissive organic layer 12 to the second organic layer 13 and favour instead the opposite travel path, whatever the type of transport (holes or electrons) of the first organic layer 11.

Similarly, the first organic layer 11 and the emissive organic layer 12 are chosen so that no substantial energy barriers are formed in any direction for the charge carriers from the first organic layer 11.

More particularly, the organic materials which form the first organic layer 11, the emissive organic layer 12 and the second organic layer 13 are chosen so as to optimize the passage of the majority and minority carriers in the organic active region 10 and in particular define suitable energy barriers at the interfaces of these layers, where the term "energy barrier" is understood as meaning the absolute value of the difference between the LUMO (Lowest Occupied Molecular Orbital) level or HOMO (Highest Occupied Molecular Orbital) level at these interfaces, considering that the electrons are blocked during the passage towards the higher energy LUMO levels, while the holes are blocked during the passage towards the lower energy HOMO levels.

In particular, the organic materials which form the first organic layer 11, the emissive organic layer 12 and the second organic layer 13 are therefore chosen so as to have:
- an energy barrier at the interface between the first organic layer 11 and the emissive organic layer 12 less than or equal to 0.6 eV for the majority charge carriers;
- an energy barrier during the passage from the emissive organic layer 12 to the first organic layer 11 equal to or greater than 0 eV for the minority charge carriers;
- an energy barrier during the passage from the emissive organic layer 12 to the second organic layer 13 greater than or equal to 0.1 eV for the majority charge carriers; and
- an energy barrier during the passage from the second organic layer 13 to the emissive organic layer 12 less than or equal to 1.5 eV for the minority charge carriers.

In the case where the interface between two layers is composed of a mixture of several materials the HOMO or LUMO levels of all the single components of the mixture should respect the given conditions.

In order to establish HOMO and LUMO values it is possible to use cyclic voltametry in a solution, U-V Photoelectron Spectroscopy (UPS), optionally integrated with ab initio calculations.

For correct operation of the OLET transistor realized by means of the multilayer structure 1, its organic active region 10 therefore comprises layers of suitable materials, able to respect the abovementioned energy constraints with suitable mobility values of the majority or minority charge carriers.

In particular, the first organic layer 11, in contact with the dielectric layer 14, namely the insulating layer of the OLET transistor, is made of a first organic material having transport properties similar to those of a unipolar field-effect transistor (FET), irrespective of the type of charge carrier (hole or electron). More particularly, this first organic material has a charge mobility greater than or equal to 10⁻² cm²/Vs. It is pointed out that this charge mobility is calculated by carrying out measurements on an organic thin film transistor OTFT, optimized solely on the basis of this first material and using the electrical characterization of standard MOSFET transistors.

The charge carrier transported by this first organic layer 11 is indicated as a majority carrier.

Preferred materials for realizing the first organic layer 11 are preferentially molecular materials referred to as "small molecules". In particular molecular materials with FET transport properties may include the oligomeric classes of thiophene derivatives, acene derivatives, perfluoroacene derivatives, perylene derivatives, derivatives of fluoroarenes, derivatives of thiophene-fluoroarenes, benzo[1,2-b:4,5-b']dichalcogenophenes (BDXs), [1]benzochalcogenopheno-[3,2-b][1]benzochalcogenophenes (BXBXs), dinaphtho[2,3-b:2',3'-f]-chalcogenopheno[3,2-b]chalcogenophenes (DNXXs). In a preferred embodiment the first organic layer 11 is made of 2,7-dioctyl[1]benzothieno[3,2-b][1]benzothiophene (C8-BTBT), N,N'-ditridecylperylene-3,4,9,10-tetracarboxylic Diimide (P13), Pentacene, Dinaphtho[2,3-b:2',3'-f]thieno[3,2-b]thiophene (DNTT), 1,3,6,8(2H,7H)-Tetraone, 2,7-dicyclohexylbenzo[lmn][3,8]phenanthroline.

The materials indicated are in fact known for their good field-effect transport (FET) properties of the p or n type, depending on the used material.

The emissive organic layer 12 is formed with a photoluminescent material, in particular with quantum yield (QY) photoluminescence values greater than 10%. Suitably, this photoluminescent material is chosen so as to have a photoluminescence spectrum centred on one of the three colour coordinates RGB, in accordance with the PAL or NTSC standard. Furthermore the used photoluminescent material to form the emissive organic layer 12 allows a bulk transport with a mobility preferably greater than or equal to 10⁻⁸ cm²/Vs, for both the majority or minority charge carriers. It is also pointed out that in this case the intrinsic bulk mobility of the emissive organic layer 12 in the form of a thin film is understood as being measured on a diode-type structure with a characterization of the time-of-flight or SCLC (Space Charge Limited Current) type.

According to one embodiment, the emissive organic layer 12 is made of a sole material. Alternatively, this emissive organic layer 12 may be made of a mixture of two or more materials. Furthermore, the emissive organic layer 12 may also comprise a stack of two or more layers, each of which may be made of a mixture of two or more materials.

Preferred materials for forming the emissive organic layer 12 are systems of the host-guest type with triplet emission.

In particular, it is possible to use Alq3 namely tris(8-hydroxyquinolinato) aluminium, known in the OLED technology sector and used to form the emissive layer of the diode.

The second organic material forming the second organic layer 13, the layer which is furthest from the dielectric layer 14, namely from the insulating layer of the OLET transistor, should have the function of blocking the majority charge carriers from the first organic layer 11 and is chosen so as to have at least these characteristics:
a) it has an energy distribution with respect to the emissive organic layer 12 capable of blocking the diffusion of the majority charge carriers from the first organic layer 11, at the interface between the emissive organic layer 12 and the second organic layer 13;
b) it has negligible field-effect transport properties, for both the majority and minority charge carriers.
   For example, the mobility of FET charge of the second organic layer 13 is at least two orders of magnitude less than that of the majority charge carriers of the first organic layer 11.
   It is emphasized that the mobility of the first organic layer 11 is to be considered as that measured on an OTFT transistor based solely on the first organic material which forms the first organic layer 11, as above. For the charging mobility of the second organic layer 13, as regards the majority carriers, the measurement is performed considering a single-layer OTFT transistor based on the second organic material which forms the second organic layer 13, while for the measurement of the FET charge mobility relating to the opposite charge carriers (minority carriers), the measurement of the mobility of the second organic layer 13 in the three-layer configuration is carried out using the characterization of a standard MOSFET transistor during polarization in accordance with the accumulation of the minority charge carriers (namely with a positive potential applied to the gate electrode 15 for the electrons and with a negative potential applied to the gate electrode 15 for the holes), in particular having a dielectric layer in contact with the first organic layer 11 and injection electrodes in contact with the second organic layer 13; and
c) it favours the bulk transport of the minority charge carriers, namely the charges with a sign opposite to that of the charges flowing in the first organic layer 11, with respect to the majority charge carriers from the drain electrode 16A to the interface with the emissive organic layer 12, over a distance of the order of 10-100 nm.

In other words, the interface between the emissive organic layer 12 and the second organic layer 13 is separated from the drain electrode 16A by a distance of at least 10 nm, so that neither the emissive organic layer 12 nor even the first organic layer 11, which is the FET transport layer, could directly contact the drain electrode 16A.

In particular, the second organic layer 13 should favour the bulk transport of the minority carriers, with respect to the majority carriers, with a volume mobility of the minority carriers at least one order of magnitude greater than the volume mobility of the majority carriers.

In operational terms, the volume mobility of the minority carriers to be measured by means of time-of-flight or SCLC characterization in a vertical diode configuration should therefore be greater than that of the majority carriers for a thin film based on the material used to form the second organic layer 13.

It is emphasized that, in the case where the thin film based on the material used to form the second organic layer 13 should have evident field-effect transport properties when used alone inside a single-layer OTFT transistor, it is possible to use also the FET mobilities to determine the charge carrier favoured inside the thin film. In this case, it is necessary for the FET mobility of the minority carrier to be greater than that of the majority carrier for such a single-layer OTFT transistor based on the material used to form the second organic layer 13.

For example, the second organic layer 13 has mobility bulk transport properties preferably greater than or equal to 10⁻⁸ cm²/Vs, for the minority carriers of the specific used three-layer configuration (in particular, electrons if the first organic layer 11 transports holes, or holes of the first organic layer 11 transports electrons). In this case also, the measurement of the bulk mobility is to be understood as being performed in the same way as for the material which forms the emissive organic layer 12.

Preferred materials for forming the second organic layer 13 are the materials used in OLED technology such as hole blocking materials or electron blocking materials. All the HOMO-LUMO gap wideband FET transport materials which have negligible FET properties in the three-layer configuration may also be effectively used.

Alternatively, it is possible to use materials which intrinsically do not have field-effect transport properties, being ordered amorphously inside an organic thin film. as in the current OLED technologies.

It is emphasized that in this case it is possible to use materials with field-effect transport properties when used on their own within a suitable transistor platform, in particular when grown directly on the dielectric layer 14 of the transistor, but which completely lose these properties when used within an organic heterojunction, namely when grown on top of another organic layer, as in the multilayer structure 1 according to the invention.

More generally, it is possible to use with success in the multilayer structure 1 according to the invention a semiconductor organic material, the field-effect transport properties of which are substantially eliminated by the presence of an underlying emissive organic layer with the energy characteristics mentioned above.

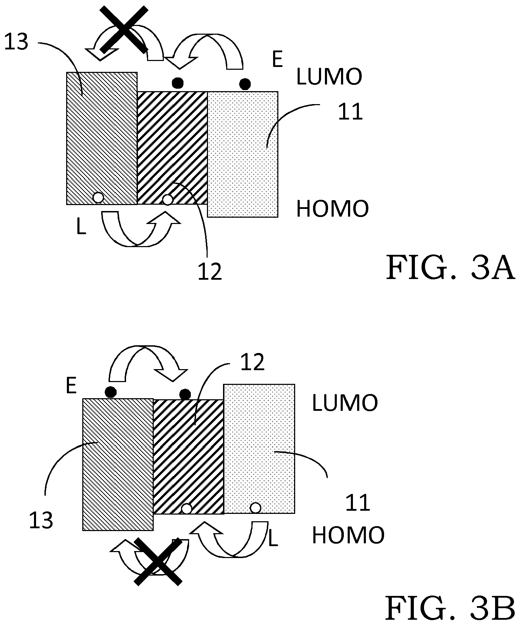

The charge blocking and passage mechanisms are shown schematically in Figures 3A and 3B according to the distribution of the HOMO and LUMO levels, respectively, of the multilayer organic active region 10.

In particular, the HOMO level is that which houses the transport of holes, indicated by L, while the LUMO level is that which supports the transport of electrons, indicated by E. During operation of the organic active region 10, the charges transported by the first organic layer 11, electrons in the case of an n-type semiconductor layer or holes in the case of a p-type semiconductor layer, are injected via the source electrode 16A into the second organic layer 13 and easily reach the first organic layer 11, passing through the emissive organic layer 12, since the energy of the multilayer organic active region 10 favours the passage of charge from the second organic layer 13 to the emissive organic layer 12, and not vice versa, as indicated in Figures 3A and 3B.

More particularly, as shown in Figures 2A and 2B, the injected charges (arrow F1), after being transported within the first organic layer 11 from the source electrode 16B to the drain electrode 16A (arrow F2) via the field effect due to the potential applied to the gate electrode 15, tend to reach by means of linear diffusion, or under the effect of the field between drain and gate in the saturation condition, the drain electrode 16A through which they are eliminated (arrow F3). The energy barrier which the charges encounter during the passage from the emissive organic layer 12 to the second organic layer 13 is such as to prevent the charges from reaching the drain electrode 16A and such as to induce the formation of localized charge at the interface between the emissive organic layer 12 and the second organic layer 13 (charge C).

This localized charge induces an electric field sufficient to trigger the injection of the minority carriers through the drain electrode 16A (arrow F4), these minority carriers being holes, if electrons circulate in the first organic layer 11 (as in Figure 2A), and electrons if holes circulate on the first organic layer 11. This therefore results in a situation, underneath the drain electrode 16A, which is entirely similar to that which occurs inside an OLED (organic light emitting diode) device, namely with two opposite-value charge fronts which meet in the vicinity of the interface with the emissive organic layer 12 and generate electroluminescence (arrow F5).

In short, advantageously according to the invention, the multilayer structure 1 comprising the organic active region 10 is able to realize an OLET transistor with the essential feature that it has an optoelectronic behaviour of the type similar to that of a MOSEFT transistor, both as regards current transport and as regards electroluminescence.

As explained, the OLET transistor thus formed comprises three driving electrodes (drain, source and gate), the organic active region 10 in which the optoelectronic functions occur and an insulating layer, in particular the dielectric layer 14, which separates the organic active region 10 of the transistor from one of the three electrodes, in particular the gate electrode 15. The remaining two electrodes, in particular the drain and source electrodes, 16A and 16B, enable and support the current passage of the OLET transistor and should be in contact with the organic active region 10 of the OLET transistor. The gate electrode 15 is thus substantially a passive electrode in the sense that its function is that of applying a uniform electric field over the entire channel of the OLET transistor, with a negligible passage of current through it, and should be in contact with the insulating layer, namely the dielectric gate layer 14 of the OLET transistor.

It is emphasized that, for correct operation of the OLET transistor realized by the multilayer structure 1 according to the invention, the dielectric gate layer 14, i.e. the insulating layer of the OLET transistor, prevents the passage of current through it for a value of at least 10³ times, preferably for a value greater than or equal to 10⁵, the passage of current between the drain electrode 16A and source electrode 16B.

It is possible to realize this dielectric layer 14 by means of a layer of PMMA (polymethylmethacrylate), characterized by a very low dielectric constant equal to about 3.6. Alternatively, it is possible to use a polymeric dielectric with a relatively higher dielectric constant, in particular with a value equal to about 50 times, namely the P(VDF-TrFE-CFE) described by Baojin Chu et al. in SCIENCE VOL. 313 21 (2006) 335. The use of dielectrics with a high dielectric constant, and in particular higher than 30, allows rescaling of the driving voltages of the organic transistor thus obtained to levels which are perfectly compatible with current application needs.

More generally, the dielectric layer 14 may be formed by means of metal oxides (such as zirconium oxide, hafnium oxide, aluminium oxide), organic materials (such as PMMA or P(VDF-TrFE-CFE) indicated above, or SU8, i.e. a very viscous polymer, commonly used as a negative photoresist on epoxies or P(VDF-TrFE-CFE), i.e. the copolymer of vinylidene fluoride-trifluoroethylene, or organic/inorganic hybrid nano-composites (as described for example in J. AM. CHEM. SOC. 2010, 132, 17426-17434 and in J. Mater. Chem., 2009, 19, 2503-2511). In all these cases, it is possible to form dielectric films with optimum optical transparency properties.

According to a preferred embodiment being particularly simple in process terms, the drain and source electrodes 16A and 16B, are in contact with a same organic layer, in particular the layer situated furthest in relation to the dielectric layer 14, i.e. the second organic layer 13. Alternatively, the source electrode 16B, i.e. the electrode which injects the charges circulating in the first organic layer 11, is placed in contact with another organic layer, in particular the first organic layer 11, while the drain electrode 16A, i.e. the electrode which attracts, collects and eliminates the charges circulating in the first organic layer 11, always remains in contact with the second organic layer 13.

The drain and source electrodes, 16A and 16B, may be made using different materials, or, in a preferred embodiment, using a same material.

The usually used material to form the drain and source electrodes, 16A and 16B, is gold (Au). Alternatively, it is possible to use other metals (such as Ag, Al, Cu, Ca, Pt), conductive oxides (such as ITO - abbreviation for indium tin oxide, more precisely, indium oxide doped with tin), or conductive organic films (such as graphene). It should be noted that the conductive oxides, such as graphene, are excellent also for formation of the gate electrode 15, since they are intrinsically transparent. Alternatively, it is possible to use metals in the form of ultra-thin films so as to maintain good transparency properties.

The OLET transistor realized by the multilayer structure 1 is completed by a substrate and an encapsulation layer, which may be made of glass or using any type of transparent plastic material, thus obtaining a flexible final optoelectronic device. It is emphasized that the plastic encapsulation material used should moreover be sufficiently impermeable to H₂O and O₂.

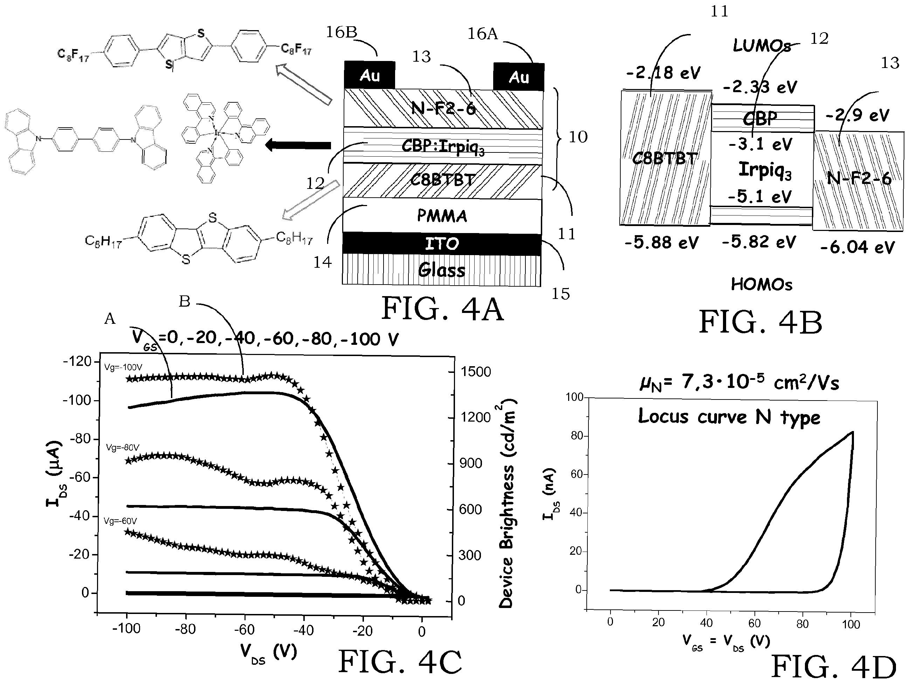

An embodiment of the multilayer structure 1 is schematically shown in Figure 4A, in a configuration of the BG-TC type.

In this case, the multilayer structure 1 comprises a glass substrate on which a gate electrode 15 made of ITO is formed.

As is well known, ITO is the conductive transparent oxide which is most widely used for the manufacturing of transparent conductive (PCT) films, the main feature of which is the combination of good electrical conductivity and optical transparency.

The multilayer structure 1 therefore comprises a dielectric layer 14 of PMMA (polymethylmethacrylate) and the organic active region 10 in turn comprising a first organic layer 11 of C8-BTBT (abbreviation for 2,7-dioctyl[1]benzothieno[3,2-b][1]benzothiophene) and a second organic layer 13 of 2,5-bis[4-(heptadecafluorooctyl)phenyl]thieno[3,2-b]thiophene which enclose an emissive organic layer 12 formed by a CBP:Irpiq₃ system, i.e. a CBP matrix, i.e. 4,4'-Bis(N-carbazolyl)-1,1'-biphenyl, in which an emissive dye of IrPiq₃, i.e. Tris[1-phenylisoquinoline-C2,N]iridium(III), is dispersed.

More particularly, the C8-BTBT which forms the first organic layer 11 has the following formula: 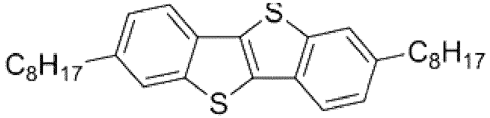 while the 2,5-bis[4-(heptadecafluorooctyl) phenyl]thieno[3,2-b]thiophene which forms the second organic layer 13 has the following formula:

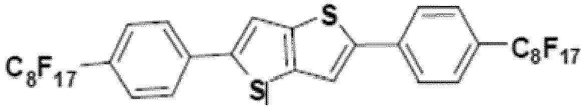

Finally, the components of the CBP:Irpiq₃ system which forms the emissive organic layer 12 have the following formula:

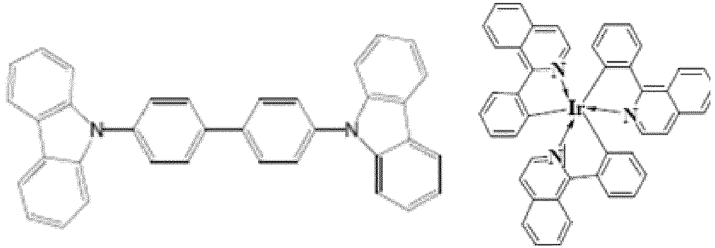

The multilayer structure 1 is completed by drain and source electrodes, 16A and 16B, made of gold and formed on the second organic layer 13 of the organic active region 10.

As schematically shown in Figure 4C, the multilayer structure 1 according to this example of embodiment allows the formation of an OLET transistor pixel which has the typical p-type MOSFET behaviour, both as regards the current flowing in the device (curves A) and as regards the brightness of the light emitted by the transistor (curves B).

In particular, during operation of the OLET transistor as a pixel, the first organic layer 11 made of C8-BTBT is the sole FET organic transport layer which generates a response in the manner of a p-type MOSFET of the OLET transistor; this first organic layer 11 is the layer making contact with the dielectric layer 14 made of PMMA. It is known in literature that C8-BTBT is a material with high field-effect hole mobility values (µ>0.1 cm²/Vs) and is therefore suitable for applications which require a high performance in terms of current, as the case of a display formed by means of an OLET transistor matrix.

Furthermore, the host:guest system composed of CBP as host matrix and Irpiq3 as emissive dye which forms the emissive organic layer 12 is a configuration well known and developed within OLED technology.

Finally, the second organic layer 13 is formed with the molecule 2,5-bis[4-(heptadecafluorooctyl)phenyl]thieno[3,2-b]thiophene which, if used on its own, may have reasonable type-n field-effect transport features, with mobility for the electrons of about 10⁻²-10⁻¹ cm²/Vs.

More particularly, in terms of energy distribution of the organic active region 10, it is the case that the holes from the first organic layer 11 of C8-BTBT, distributed within the CBP:Irpiq3 system which forms the emissive organic layer 12, encounter a first maximum energy barrier of 0.5 V at the interface with the second organic layer 13 of 2,5-bis[4-(heptadecafluorooctyl)phenyl]thieno[3,2-b]thiophene, in line with the aforementioned requirements for the OLET transistor. This first energy barrier relates, in particular, to the HOMO levels of the Irpq3, the emissive material, which is in a variable percentage amount of between 10% and 20%, and the molecule of 2,5-bis[4-(heptadecafluorooctyl)phenyl]thieno[3,2-b]thiophene which forms the second organic layer 13, as indicated in Figure 4B.

Similarly, it is possible to establish that there is a second energy barrier for the holes equal to about 0.2 eV between the HOMO level of the CBP matrix of the emissive organic layer 12 and the HOMO level of the second organic layer 13 of 2,5-bis[4-(heptadecafluorooctyl)phenyl]thieno[3,2-b]thiophene, also in line with the already discussed requirements.

Finally, as regards the charge mobility, it is possible to establish that an OTFT transistor based on the molecule of 2,5-bis[4-(heptadecafluorooctyl)phenyl]thieno[3,2-b]thiophene for forming the second organic layer 13 has an electron mobility equal to a 9.2 10⁻² cm²/Vs, for a geometrical form of the transistor with L=12 mm and W=70 µm, and, if grown in a three-layer configuration as for the organic active region 10 according to the invention, the field-effect transport properties substantially deteriorate, limiting the passage of electrons across the second organic layer 13 of 2,5-bis[4-(heptadecafluorooctyl)phenyl]thieno[3,2-b]thiophene by more than four orders of magnitude and adjusting the mobility of the transistor to values of the order of 10⁻⁴-10⁻⁵ cm²/Vs.

It is emphasized that, although not zero, the residual field-effect transport across the second organic layer 13 of 2,5-bis[4-(heptadecafluorooctyl)phenyl]thieno[3,2-b]thiophene may therefore be regarded as negligible for the purposes of correct operation of the OLET transistor with the essential features as required for an optoelectronic application such as a display as indicated above.

In this way, an organic display formed by a matrix of OLET transistors as described above has a confined light emission mainly coinciding with the drain electrode of the transistor. In particular, it is obviously necessary that the light should be able to cross efficiently the drain electrode 16A, or the dielectric layer 14 and the gate electrode 15, so that it is perceived on the outside of the OLET transistor.

It is emphasized in this connection that, since the drain electrode 16A should be able to withstand the transport of current inside the OLET transistor, it is preferable to introduce optical transparency, or semitransparency, constraints into other components of the transistor, and in particular the dielectric layer 14 and the gate electrode 15, which have a passive role in connection with the functionality of the OLET transistor, with preference for the BG-TC configuration with emission at the gate electrode 15 (bottom emission), as shown in Figure 2A.

Furthermore, it can be established that, by means of a suitable design of the organic active region 10, it is possible to increase also the efficiency of the OLET transistor as well as modulate the colour coordinate of the OLET pixel in the RGB spectrum and its brightness.

In a variation of embodiment it is possible to consider an organic active region 10 in which, instead of the CBP as host matrix in the emissive organic layer 12, a derivative thereof being terminated with branched alkyl chains and having the following formula is used:

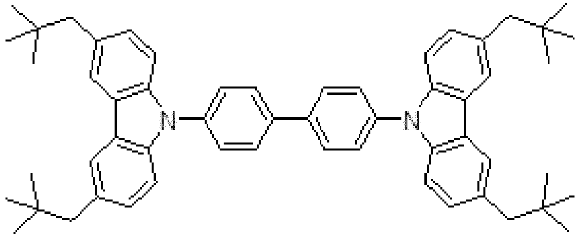

Moreover, silver (Ag) is used instead of gold (Au) for formation of the drain and source electrodes, 16A and 16B.

It can be thus verified that the variations introduced, although minimal, induce an increase in the external quantum efficiency of the OLET transistor of up to 5%, with a consequent improvement in the light power emitted equal to one order of magnitude, for the same current flowing in the OLET transistor. In particular, a pixel formed by such an OLET transistor has brightness values of the order of 4000 cd/ m².

It should be pointed out that the measurement of the luminous power emitted by an emissive source in the form of an OLET transistor and its brightness do not necessarily vary in a linear manner since the brightness value is associated with the physical dimensions of the emissive area, which may change depending on the organic configuration adopted for the transistor, while the power emitted is independent of the extension and the form of the emissive region.

It is emphasized in this respect that an efficiency of 5% is already able to surpass the performance of OLED diodes used in the current AMOLED technology.

It can be also verified that it is possible to replace the material which forms the gate electrode 15 by adopting instead ITO, an inorganic material, which is costly in terms of raw material and is very friable, thus limiting the potential flexibility of the transistor, a conductive, transparent, organic and completely flexible sheet of graphene with a thickness of about 5 nm, without affecting in any way the performance of the transistor.

In fact, in an OLET transistor realized by the multilayer structure 1 according to the invention, the gate electrode does not have active functions such as injection or collection of the charge, but only passive functions, having as sole functionality that of providing the transistor channel with a constant and uniform electric field.

By using graphene to form the gate electrode, it is possible to realize a structure which is fully compatible with all those applications which require mechanical properties similar to those of a normal plastic sheet.

Advantageously, according to the invention, the multilayer structure 1 is used to form an elementary unit for an emissive screen or display, which may be referred to as a "sub-pixel" 20.

These elementary units or sub-pixels 20 are essentially units for selecting and controlling single pixels formed by means of an OLET transistor and are active during operation of the display.

More particularly, the sub-pixels 20 are repeated the same for all the pixels forming the display in accordance with a matrix configuration (n,m) of elements which may be uniquely selected by a simultaneous electrical activation of a given row (n) and a given column (m). The sub-pixels 20 are therefore connected together in a row and column structure by at least two selection lines.

In its most general form, a sub-pixel 20 comprises at least one OLET transistor realized by means of a multilayer structure 1 as described above. The OLET transistor is the emissive source of the pixel and is coupled, by means of its contact electrodes, in particular the drain and source electrodes, between a first voltage reference, or supply reference VDD, and a second voltage reference, or ground reference GND.

It is emphasized that the multilayer structure 1 which forms the OLET transistor incorporates a capacitor used to memorize a status of the pixel during each single frame scan of the display. More particularly, the multilayer structure 1 of the OLET transistor forms intrinsically a capacitor between the drain electrode and source electrode, 16A and 16B, and the gate electrode 15.

The sub-pixel 20 further comprises at least one addressing and control transistor having at least one of the contact or injection electrodes connected to the gate electrode EG1 of the OLET transistor and a gate electrode connected to a first selection line (Select Line 1). Conveniently, the addressing and control transistor is realized by means of an organic thin film transistor OTFT.

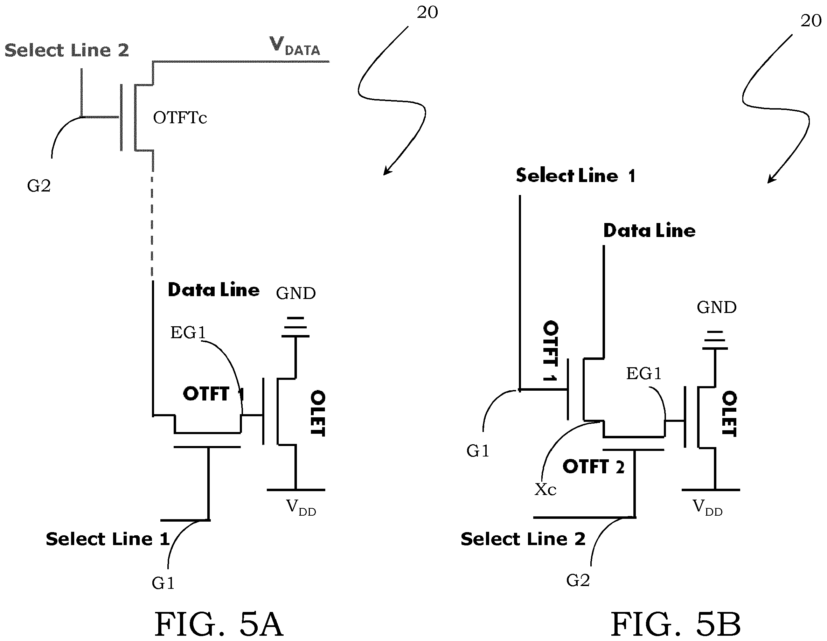

More particularly, according to a first configuration of the sub-pixel 20, shown schematically in Figure 5A, the sub-pixel 20 comprises a single addressing and control transistor OTFT1, coupled by means of its contact electrodes, in particular the drain and source electrodes, between the gate terminal EG1 of the OLET transistor and a data line (Data Line).

In this case, it is necessary to envisage using at least one additional transistor OFTCc common to an entire row (column), coupled by means its contact electrodes, in particular the drain and source electrodes, between a data voltage reference VDATA and the data line (Data Line) of each sub-pixel 20. The common transistor OTFTc also has a gate terminal G2 connected to a second selection line (Select Line 2).

Suitably, the common OTFT transistors are formed in the frame of the display, situated upstream of the matrix of sub-pixels 20.

Alternatively, as schematically shown in Figure 5B, each sub-pixel 20 comprises a first and a second addressing and control transistor OTFT1 and OTFT2 respectively electrically connected together by means of one of the injection electrodes in a common terminal Xc. In this way, the first addressing and control transistor OTFT1 is coupled between the data line (Data Line) and the common terminal Xc and has the gate electrode G1 connected to a first selection line (Select Line 1). Furthermore, the second addressing and control transistor OTFT2 is coupled between the gate electrode EG1 of the OLET transistor and the common terminal Xc and has a gate electrode G2 connected to a second selection line (Select Line 2).

The configuration of the sub-pixels 20 shown in Figures 5A is that closest to the current AMOLED technology already effectively tested and in use, in particular in the market of smart phones. Compared to a conventional configuration, advantageously according to the invention, only an OLET transistor is used instead of the combination of an OLED diode and a power supply transistor. Moreover the OLET transistor formed by the organic active region 10 according to the invention incorporates a capacitor between the drain and source electrodes, 16A and 16B, and the gate electrode 15, which may be used to stabilize the performance of the emissive element realized by the said OLET transistor during the operating phases of the respective pixel in each frame scan.

In particular by suitably defining the dimensions of the OLET transistor, and more particularly the capacitor between the drain electrode (connected to the supply reference VDD) and/or the source terminal (connected to the ground reference GND) and the gate electrode, it is possible to use this capacitor as a memory for the status of the pixel for the duration of the single frame scan of the display and also prevent possible instability present in the supply voltage reference, thus managing to reproduce this advantageous feature of the conventional AMOLED screens, where however said capacitor is usually a separate element.

It is emphasized, however, that, advantageously, according to the invention, by using an OLET transistor realized by means of a multilayer structure 1, such a capacitor is implicitly integrated monolithically inside the OLET transistor itself.

Let us now consider operation of the sub-pixels 20, based on the configuration shown in Figure 5A. In this case, the addressing of each matrix element, performed by means of the lines Data Line and Select Line 1, activates the single pixel formed by the OLET transistor solely via the addressing and control transistor OTFT1 connected to the gate electrode EG1 of the OLET transistor.

In particular, when the two lines Data Line and Select Line, connected to one of the injection electrodes and to the gate electrode G1, respectively, of the addressing and control transistor OTFT1, are both in the ON state, a current passage may then be established from the power supply network of the display comprising the sub-pixels 20 in a matrix format towards the gate electrode of the OLET transistor, via the addressing and control transistor OTFT1; in all the other cases, the gate electrode EG1 of the OLET transistor is "isolated" from the remainder of the display network. When the sub-pixel 20 is activated, i.e. in write mode, the addressing and control transistor OTFT1 allows passage of the charge which is stored in the gate electrode 15 of the OLET transistor, and in its integrated capacitor, and which allows the pixel formed by means of the OLET transistor to be kept active at a desired intensity value for the entire duration of the single frame scan.

For most of the time, the sub-pixel 20 is therefore in emissive mode, and the OLET transistor, "isolated" from the electrical power supply network of the display, emits light at a charge value stored beforehand in the gate electrode 15 and in its integrated capacitor.

As already mentioned, for this first configuration shown in Figure 5A, the data line (Data Line) is also connected to a further addressing and control transistor OTFTc, which is common to the entire row (column) of the pixel matrix, not included in the repeated structure of the sub-pixel 20.

In this way, in order to activate the data line (Data Line) it is necessary to activate the gate electrode G2 of the additional addressing and control transistor OTFTc, by means of the second selection line (Select Line 2). When also the first selection line (Select Line 1), which activates the gate electrode G1 of the addressing and control transistor OTFT1, is in the ON state, the voltage value of the data voltage reference VDATA is transmitted, in equilibrium conditions, to the gate electrode EG1 of the OLET transistor, after a charging time.

The drain electrode of the OLET transistor is instead supplied with voltage by the supply voltage reference VDD, common to the entire matrix of sub-pixels 20 and thus to the entire display, while all the source electrodes of the OLET transistors are connected to ground. It is emphasized that a sufficiently high supply voltage volume VDD is suitably applied such as to cause saturation of the OLET transistors, for any value of voltage applied to the respective gate electrodes EG 1.

Essentially, by making use of the MOSFET type optoelectronic features of the multilayer structure 1 according to the present invention, the current and the intensity of light emitted by the OLET transistor depend exclusively on the value of the voltage VDATA applied to the gate electrode EG1 of the OLET transistor via the data line (Data Line). In this way, it is possible to control the colour intensity of the pixel realized by the OLET transistor by means of the voltage value of the data line (Data Line).

The alternative sub-pixel configuration 20 shown in Figure 5B, although more complex from the point of view of the circuit architecture of each single sub-pixel, could be preferable for the realization of a display with matrix of OLET transistors, independent of the dimensions of the display itself. It is in fact clear that, in the sub-pixel configuration 20 shown in Figure 5A, the performance of the common addressing and control transistor OTFTc must diminish with the size of the display, each common addressing and control transistor OTFTc being intended for an entire row (column), in order to maintain a charging time which is compatible with good operation of the display. In some cases it could therefore prove necessary to use inorganic components to realize these common addressing and control transistors OTFc so as not to limit the display area.

In the case of the sub-pixel configuration 20 shown in Figure 5B, the addressing of each sub-pixel 20 as a matrix element which activates a single pixel formed by an OLET transistor is performed by means of the first and the second common addressing and control transistors, OTFT1 and OTFT2, both organic transistors, which are connected in sequence to the gate electrode EG1 of the OLET transistor and which define the rows and columns of the display by means of the two selection lines (Select Line 1, Select Line 2).

During writing of the sub-pixel 20, when the voltage signal of the first and second selection lines (Select Line 1, Select Line 2) are both in the ON state, the first and second addressing and control transistors, OTFT1 and OTFT2, activate the electrical connection between the data line (Data Line) and the gate electrode EG1 of the OLET transistor. In this way, the charge needed to activate the pixel at a desired intensity value for the duration of the single frame scan is stored in the gate electrode EG1 of the OLET transistor and in particular in its integrated capacitor, with memory function.

In equilibrium conditions, the gate electrode EG1 of the OLET transistor reaches a supply voltage value of the data line (Data Line). During the emission phase, when the OLET pixel is "isolated" from the electrical network of the display, it emits light based on the charge value stored beforehand in the gate electrode and in the intrinsic capacitor of the OLET transistor, upon activation of the supply line VDD.

Furthermore, the drain electrode of the OLET transistor is supplied with voltage by the supply line VDD, common to the entire display, while all the source electrodes are connected to ground. Also in this case, the voltage value applied by the supply line VDD is chosen so as to be sufficiently high to cause saturation of the OLET transistor, for any voltage value applied to the gate electrode. In this way, by making use of the MOSFET type optoelectronic characteristics of the OLET transistor realized by the multilayer structure 1 according to the invention, it is possible to ensure that the current and the light intensity emitted by the OLET transistor depend exclusively on the charge accumulated in the gate electrode via the data line (Data Line). In other words, it is possible to control the colour intensity of the pixel formed by the OLET via the data line (Data Line).

It is emphasized that in both configurations shown for the sub-pixel 20, operation of the display is independent of the type of transport, whether of the p-type or n-type, of the addressing and control transistors OTFT1 and OTFT2, which may therefore be chosen so as to maximize performance (high charge mobility, low gate thresholds).

The basic process for realization of a display formed by a matrix of OLET transistors having the multi-layer structure 1 according to the invention is preferably assumed to be that of vacuum deposition which may involve atomic beams, molecular beams or nanoparticles. Also to be considered are processes using liquid means (such as spin-coating, doctor blade or ink jet printing techniques), in particular as regards the dielectric layer 14, as well as chemical vapour deposition (CVD) processes for forming conductive organic films such as ultra-thin sheets of conductive graphene for example for the gate electrode 15.

More particularly, the deposition of the vacuum materials is preferably obtained by means of Knudsen cells. Alternatively, it is possible to use electron-gun or ion-gun sources and sputtering processes.

Finally, the process for realization of the OLET transistor may use the material which forms the first organic layer 11 of the organic active region 10 also for the manufacture of the addressing and control transistors OTFT1 and OTFT2.

It is emphasized that all the parts of the display realized by means of a vacuum deposition process may be micro-defined during a process for growing a thin film, by means of suitable masks arranged between the evaporation source and the sample. Furthermore, the parts made by means of solution-based processes, using for example spin-coating or doctor blade techniques, may be micro-defined subsequently by means of a photolithography process where the used material has the appropriate photochemical properties.

For example, it is possible to realize an insulating layer of the row-column lines of the OLET matrix which forms the display by means of a common photoresist and a photolithographic definition.

In this respect, of particular interest are so-called "high-k" polymers which may be used to manufacture the dielectric layer 14 of the OLET transistors forming the OLET display.

It should be noted that the multi-layer structure 1 according to the invention may also be realized, although not necessarily, using entire dielectric surfaces which do not need to be micro-defined. It is emphasized that the use of a single extended dielectric surface fixes the configuration of the entire sub-pixel, once the configuration of the OLET transistor has been determined, and that, in the case of the embodiment shown in Figure 5A, since one of the injection electrodes of the addressing and control transistor OTFT should be connected to the gate electrode of the OLET transistor, the contact configurations of the OLET transistor and the addressing and control transistor OTFT1 should necessarily be opposite, namely when one is BG-TC, the other one should necessarily be TG-BC; moreover, in the case of the embodiment shown in Figure 5B, the contact configuration of the second addressing and control transistor OTFT2 should be the same as that used for the first addressing and control transistor OTFT1 in order to be able to use a single extended dielectric surface.

The possibility of being able to micro-define all the display elements instead allows the sub-pixels to be formed in a simple manner using the same architecture for all the OLET transistors and the addressing and control transistors OTFT. It should be pointed out that these integrated embodiments may be particularly convenient for optimizing the performance of all the single components of the sub-pixel 20. In many cases, in fact, in particular when the organic electronic elements are based on small molecules, the contact configuration of the type BG-TC is that which allows the best control during formation of the organic active region 10, and therefore the best control over performance, stability and reproducibility characteristics of the OLET transistor and of the addressing and control transistors OTFT1 and OTFT2.

Basically, the configurations described for realization of the elementary sub-pixel units of the display may be achieved both by using confined dielectric planes and by using one or more extended dielectric planes.

It is in fact not necessarily the case that a dielectric material which has optimum insulation and electrical capacitance properties is also compatible with spatial confinement processes such as masking, photolithography or chemical lithography. This characteristic does not adversely affect the formation of a display comprising OLET transistors realized with the multilayer structure 1 according to the invention and according the configurations shown in Figures 5A and 5B, except that it may complicate the realization thereof in terms of the total number of process steps.

Furthermore, it is emphasized that all the possible permutations of the configurations BG-TC and TC-BG of the various elements of the sub-pixels (transistors OTFT1, OTFT2 and OLET) may be realized using both confined and extended dielectric planes.

It should also be emphasized that the data lines (Data Line) and the selection line (Select Line 1) for the first sub-pixel configuration 20 of Figure 5A and the first and second selection lines (Select Line 1 and Select Line 2) for the second sub-pixel configuration 20 of Figure 5B should not interact electrically with each other and are therefore, during the integration process, vertically separated from each other by a layer of insulating material with a low dielectric constant.

Furthermore, in the integrated embodiments, the intrinsic capacitor of the OLET transistor able to store the status of each pixel formed by it during the single scan of the display frame is integrated inside the same OLET transistor. In general, the intrinsic capacitor of the OLET transistor may comprise as plates the drain and gate electrodes or the source and gate electrodes, between which it is possible to store charge and therefore the status of the pixel.

In particular, it is possible to consider an intrinsic capacitor of the OLET transistor as having, as plates, the drain electrode (or source electrode) of the OLET transistor and the portion of the gate electrode underlying it, while the insulating region of the capacitor is formed by the portion of the dielectric layer 14 of the OLET transistor situated underneath the drain electrode (or source electrode) and the overlying organic active region portion 10.

It is also possible to consider an intrinsic capacitor of the OLET transistor as having, as plates, still the drain electrode (or source electrode) of the OLET transistor and the portion of the gate electrode situated underneath it, while the insulating region is formed solely by the portion of the dielectric layer 14 of the OLET transistor situated underneath the drain electrode (or source electrode). This configuration of the OLET transistor and its intrinsic capacitor is particularly recommended when, in the case of using a high-k dielectric material for realization of the OLET transistor, it is wished to exploit fully the capacity per unit of surface area of the pixel memory and, consequently, minimize the surface area used for this memory function, to the advantage of the total surface area which can be used to amplify the emissive region of the sub-pixel.

In this case, due to the positioning of the stacked organic active region between the two plates and by using a high-k dielectric material for realization of the OLET transistor, the total capacity which may be used as memory for the OLET pixel is significantly reduced. Organic films are in fact characterized by typically low dielectric constant values (< 10) and, when stacked in parallel with a high-k dielectric, they reduce the total capacity to values which are all the closer to those of the organic material, the higher the capacity of the high-k dielectric. In other words, the stacked arrangement of organic layers of the organic active region 10 eliminates the potential of the high-k material. This results in the need to use extended surface areas for the capacitor with pixel memory function, this limiting the total area for each sub-pixel which can be used to amplify the emissive surface of the OLET transistor. This configuration, however, is simpler from the point of view of practical implementation, i.e. in terms of the precision and resolution requirements of the masking process and of the total number of process steps.

Basically, the memory of the sub-pixel may be naturally integrated in the OLET transistor making use of the area comprised between the gate electrode and the source and drain electrodes, the maximum capacity of the integrated memory being determined by the extension of the contact area and by the value of the dielectric constant of the insulating layer.

It is emphasized that the figures and diagrams being shown therein are not intended to represent the real relative dimensions, the real relative positions and the real geometrical configurations of the addressing and control transistors OTFT and the OLET transistor as emissive source. The relative dimensions of the OTFT and OLET transistors will be determined by the real performance of the devices, and the real geometry of the sub-pixel should optimize the spaces in order to increase the resolution of the entire OLET display.

In particular, the higher the mobility of the addressing and control transistors OTFT, the smaller will be the dimensions required of them. Similarly, the higher the brightness value of the OLET transistor as emissive source, the smaller will be the size required of this transistor. Finally, the higher the capacitance of the dielectric layer of the addressing and control transistors OTFT and the OLET transistor, the smaller will be the size of the surface area of the capacitor required as memory by the sub-pixel.

The charging time of the single pixel will also depend on the performance of the single elements and/or their geometry. The greater in fact the value of the current passing through the addressing and control transistors OTFT, the smaller will be the time required to store the charge in the capacitor with the OLET pixel memory function.

It is possible to consider for each sub-pixel 20 geometries with interdigitated electrodes, when it is required to extend the active area of each single component, in order to increase the total current flowing in the addressing and control transistors OTFT, or the total emissive area of the OLET transistor.

By way of conclusion, with the multilayer structure 1 according to the invention it is possible to realize an OLET transistor as emissive source able to form a pixel of an organic display.

The main features of the proposed structure are mentioned below.
1) The second organic layer 13 is a layer that has the function of preventing the majority charge carriers coming from the first organic layer 11, which is the FET transport layer, to reach the drain electrode 16A, and in particular by blocking them inside the emissive organic layer 12 at the interface with the second organic layer 13, and, at the same time, to prevent the minority charge carriers from crossing the channel of the transistor thus obtained, starting from the drain electrode 16A to reach the source electrode 16B, for any potential value applied to the gate electrode of the transistor.
   To do this, the second organic layer 13 is interposed between the emissive organic layer 12 and the drain electrode 16A with a thickness of at least 10 nm, while having an unfavourable energy barrier for the majority carriers and not favouring the volume transport in its inside, and also preventing the field effect charge transport.
2) By meeting the above listed conditions, a device having the electrical characteristics of a unipolar transistor is obtained, with a clear evidence of an OFF state of the transistor when a null value is applied to its gate electrode (Vgate=0), and an ON state of the transistor when the potential values applied to the gate electrode are higher than a threshold voltage value (Vgate>Vthreshold) and a current saturation state when the values applied to the gate electrode are less than or equal to the voltage delta applied between the source and drain electrodes (Vgate-Vtheshold<=Vds). It is thus obtained a transistor behaving as a MOSFET transistor, in a perfect correspondence whith the conventional digital electronics.
3) The light generation is confined within the emissive organic layer 12 thanks to an optimal distribution of the energy levels of the three layers heterojunction, as described, and is confined to below the drain electrode 16A, cancelling any light emission from the transistor channel.

More particularly, advantageously according to the invention, the multilayer structure 1 comprising the organic active region 10 is able to realize an OLET transistor with an optoelectronic behaviour which is in each and every respect similar to that of a MOSFET transistor, both as regards current transport and as regards electroluminescence.

In this sense, the light emission of the OLET transistor realized by the multilayer structure 1 is to be regarded as being substantially proportional to the current flowing in the transistor itself and therefore also has the same functional dependency on the control potentials, which is characteristic of a MOSFET transistor, and is characterized by a linear region and by a saturation region, dependent on the potentials applied to the OLET transistor. The electroluminescence and current operating regions may be regarded as substantially superimposable.

Conveniently, the control electrode of this transistor, in particular the gate electrode, is substantially a passive electrode in the sense that its function is that of applying a uniform electric field over the entire channel of the OLET transistor, with a negligible current passage through it, and therefore may be realized using graphene, with undoubted advantages over the materials currently used, in particular ITO.

Furthermore, advantageously according to the invention, the dielectric gate layer, namely the insulating layer of the OLET transistor, prevents the passage of current through it.

In particular the use of dielectrics with a high dielectric constant allows rescaling of the driving voltages of the organic transistor thus obtained to levels which are perfectly compatible with current application needs, such as those of a display or screen of the AMOLED type, for example.

Moreover, as emissive element, the OLET transistor realized by means of the multilayer structure 1 according to the invention may be controlled with regard to its colour intensity in same way as a conventional MOSFET transistor, namely via the gate voltage or potential. In fact, such an OLET transistor naturally incorporates the functions which in AMOLED screens are nowadays performed by the combination of an OLED diode and its current supply transistor present in the active matrix. Since it is precisely this current supply transistor of the OLED diode which is the element which requires charge mobility values incompatible with organic technology, the use of an OLET transistor as emissive element eliminates ab initio the need, resulting in the possibility of providing a screen which is completely organic.

More particularly, in a matrix of OLET transistors, control of the status of each OLET transistor during scanning of the various frames of the screen realized by this matrix is performed by means of the gate electrode, which, being electrically substantially equivalent to a plate of a capacitor, does not dissipate current and therefore does not require high current values in order to be activated and charged. In this way, the entire architecture for row-column addressing and for controlling the pixels of a screen formed by a matrix of OLET transistors is realized using only organic components.

Furthermore, the multilayer structure of the OLET transistor integrates an intrinsic capacitor, comprising the drain and gate electrodes or the source and gate electrodes as plates and an insulating region is composed of a portion of the dielectric layer of the OLET transistor itself, this intrinsic capacitor being conveniently able to store the status of each pixel formed by it during the single frame scan of the display. Finally it is possible to achieve further advantages using organic thin film transistor technology (OTFT).

## Claims

1. A multilayer structure (1) of an OLET transistor realized on at least one substrate, comprising at least one emissive organic layer (12) and provided with a first and a second injection electrode (16A, 16B) and a control electrode (15), comprising at least one organic active region (10) composed of a sequence of three organic layers :
- a first organic layer (11) having field-effect transport properties;
- said emissive organic layer (12), and
- a second organic layer (13) having the function of blocking the majority charge carriers from said first organic layer (11), said emissive organic layer (12) being sandwiched between said first and second organic layers (11, 13), as well as
at least one dielectric layer (14) which separates said control electrode (15) from said organic active region (10) and is in contact with said first organic layer (11), said first injection electrode (16A) being in contact with said second organic layer (13), wherein
said second organic layer (13) is made from an organic material having the following characteristics:
a) it has an energy distribution with respect to said emissive organic layer (12) capable of blocking the diffusion of the majority charge carriers from said first organic layer (11), by generating, at the interface between said emissive organic layer (12) and said second organic layer (13), an energy barrier during the passage from said emissive organic layer (12) to said second organic layer (13) greater than or equal to 0.1 eV for the majority charge carriers where the term "energy barrier" is understood as meaning the absolute value of the difference between the LUMO (Lowest Occupied Molecular Orbital) levels or HOMO (Highest Occupied Molecular Orbital) levels of the materials at said interface;
said organic materials which form said first organic layer (11), said emissive organic layer (12) and said second organic layer (13) form energy barriers at their interfaces chosen as follows
- an energy barrier at the interface between said first organic layer (11) and said emissive organic layer (12) less than or equal to 0.6 eV for the majority charge carriers;
- an energy barrier during the passage from said emissive organic layer (12) to said first organic layer (11) equal to or greater than 0 eV for the minority charge carriers; and
- an energy barrier during the passage from said second organic layer (13) to said emissive organic layer (12) less than or equal to 1.5 eV for the minority charge carriers;
b) it has a charge mobility which is at least two orders of magnitude less than that of the majority charge carriers of said first organic layer (11), the mobility of said first organic layer (11) being measured on an OTFT transistor based solely on said first organic layer (11), while the mobility of said second organic layer (13) is measured for the majority charge carriers on an OTFT transistor based solely on said organic material forming said second organic layer (13) and for the minority charge carriers on an OTFT transistor comprising the three-layer configuration of said organic active region (10) having a dielectric layer in contact with said first organic layer (11) and injection electrodes in contact with said second organic layer (13); and
c) it favours the bulk transport of the minority charge carriers compared to the majority charge carriers from said first injection electrode (16A) to the interface with said emissive organic layer (12) by having a volume mobility of the minority carriers at least one order of magnitude greater than the volume mobility of the majority carriers, said interface being separated from said first injection electrode (16A) by a distance of at least 10 nm.

2. The multilayer structure (1) of an OLET transistor according to claim 1, **characterized in that** said emissive organic layer (12) is formed by a system of the host-guest type with triplet emission.

3. The multilayer structure (1) of an OLET transistor according to any one of the preceding claims, **characterized in that** said emissive organic layer (12) is made of a mixture of several materials.

4. The multilayer structure (1) of an OLET transistor according to any one of the preceding claims, **characterized in that** said emissive organic layer (12) comprises a stack of two or more layers, at least one of said layers being optionally made of a mixture of several materials.

5. The multilayer structure (1) of an OLET transistor according to any one of the preceding claims, **characterized in that** said dielectric layer (14) prevents the passage of current through it for a value of at least 10³ times, preferably for a value greater than or equal to 10⁵, with respect to the passage of current between the injection electrodes (16A, 16B).

6. Elementary emissive unit or sub-pixel (20), **characterized by** comprising, as an emissive element, an OLET transistor realized by means of a multilayer structure (1) according to any one of the preceding claims.

7. Elementary emissive unit or sub-pixel (20) according to claim 6, **characterized in that** said OLET transistor is coupled via its injection electrodes (16A, 16B), between a first supply voltage reference (VDD), and a second ground voltage reference (GND) and **in that** it further comprises at least one addressing and control transistor having at least one of the injection electrodes connected to a control electrode (EG1) of said OLET transistor and a control electrode connected to a first selection line (Select Line 1).

8. Elementary emissive unit or sub-pixel (20) according to claim 7, **characterized in that** said addressing and control transistor (OTFT1) is coupled via its injection electrodes, between said control terminal (EG1) of said OLET transistor and a data line (Data Line).

9. Elementary emissive unit or sub-pixel (20) according to claim 8, **characterized in that** it is further connected to a transistor (OTFTc) common to an entire row or column of elementary emissive units or sub-pixels (20), coupled by means of its injection electrodes, between a data voltage reference (VDATA) and said data line (Data Line) of each elementary emissive unit or sub-pixel (20) and having a gate terminal (G2) connected to a second selection line (Select Line 2).

10. Elementary emissive unit or sub-pixel (20) according to claim 7, **characterized by** comprising a first and a second addressing and control transistor (OTFT1, OTFT2), respectively, electrically connected to each other via one of the injection electrodes in a common terminal (Xc), said first addressing and control transistor (OTFT1) being coupled between said data line (Data Line) and said common terminal (Xc) and having a control electrode (G1) connected to a first selection line (Select Line 1), while said second addressing and control transistor (OTFT2) is coupled between said gate electrode (EG1) of said OLET transistor and said common terminal (Xc) and has a control electrode (G2) connected to a second selection line (Select Line 2).

11. Elementary emissive unit or sub-pixel (20) according to any one of claims 6 to 10, **characterized in that** said OLET transistor comprises an integrated intrinsic capacitor having, as plates, one of said injection electrodes (16A, 16B) and said control electrode (EG1) and, as insulating region, a portion of a dielectric layer (14) which separates said control electrode (EG1) from an organic active region (10), this intrinsic capacitor being able to store a status of said pixel realized by said OLET transistor.

12. Display comprising a matrix configuration (n, m) of elementary emissive units according to any one of claims 6 to 11.

## Patentansprüche

1. Eine Mehrschichtstruktur (1) eines OLET-Transistors, die auf mindestens einem Substrat realisiert ist, die mindestens eine emittierende organische Schicht (12) aufweist und mit einer ersten und einer zweiten Injektionselektrode (16A, 16B) und einer Steuerelektrode (15) versehen ist, aufweisend mindestens einen organischen aktiven Bereich (10), der aus einer Abfolge von drei organischen Schichten zusammengesetzt ist:
- einer ersten organischen Schicht (11) mit Feldeffekttransporteigenschaften;
- der genannten emittierenden organischen Schicht (12), und
- einer zweiten organischen Schicht (13) mit der Funktion des Blockierens der Majoritätsladungsträger aus der ersten organischen Schicht (11), die genannte emittierende organische Schicht (12) ist geschichtet zwischen der ersten und der zweiten organischen Schicht (11, 13) angeordnet, sowie
mindestens eine dielektrische Schicht (14), die die genannte Steuerelektrode (15) von dem genannten organischen aktiven Bereich (10) trennt und in Kontakt mit der genannten ersten organischen Schicht (11) ist, wobei die genannte erste Injektionselektrode (16A) mit der genannten zweiten organischen Schicht (13) in Kontakt steht, wobei
die genannte zweite organische Schicht (13) aus einem organischen Material mit folgenden Eigenschaften hergestellt ist:
a) es weist eine Energieverteilung bezüglich der emittierenden organischen
Schicht (12) auf, die in der Lage ist, die Diffusion der Majoritätsladungsträger von der genannten ersten organischen Schicht zu blockieren (11), indem sie an der Grenzfläche zwischen der genannten emittierenden organischen Schicht (12) und der genannten zweiten organischen Schicht (13) eine Energiebarriere während des Durchgangs von der genannten emittierenden organischen Schicht (12) zu der genannten zweiten organischen Schicht (13) grösser oder gleich 0,1 eV für die Majoritätsladungsträger erzeugt, wobei unter Energiebarriere der Absolutwert der Differenz zwischen den LUMO (niedrigstes besetztes Molekülorbital) Niveaus oder den HOMO (höchstes besetztes Molekülorbital) Niveaus der Materialien an der besagten Grenzfläche verstanden wird;
die genannten organischen Materialien, die genannte erste organische Schicht (11), die genannte emittierende organische Schicht (12) und die genannte zweite organische Schicht (13) bilden, bilden an ihren Grenzflächen Energiebarrieren, die wie folgt gewählt sind
- eine Energiebarriere an der Grenzfläche zwischen der genannten ersten organischen Schicht (11) und der genannten emittierenden organischen Schicht (12) kleiner oder gleich 0,6 eV für
die Majoritätsladungsträger;
- eine Energiebarriere während des Durchgangs von der genannten emittierenden organischen Schicht (12) zu der genannten ersten organischen Schicht (11) gleich oder grösser als 0 eV für die Minoritätsladungsträger; und
- eine Energiebarriere während des Durchgangs von der genannten zweiten organischen Schicht (13) zu der genannten emittierenden organischen Schicht (12) kleiner oder gleich 1,5 eV für die Minoritätsladungsträger;
b) es weist eine Ladungsträgerbeweglichkeit auf, die mindestens zwei Größenordnungen kleiner ist als diejenige der Majoritätsladungsträger der genannten ersten organischen Schicht
(11), wobei die Beweglichkeit der genannten ersten organischen Schicht (11) an einem OTFT-Transistor gemessen wird, der ausschließlich auf der genannten ersten organischen Schicht (11) basiert, während die Beweglichkeit der genannten zweiten organischen Schicht (13) für die Majoritätsladungsträger an einem OTFT-Transistor gemessen wird, der ausschließlich auf dem genannten, die genannte zweite organische Schicht (13) bildenden organischen Material basiert und für die Minoritätsladungsträger an einem OTFT-Transistor, der die dreischichtige Struktur des genannten organischen aktiven Bereichs (10) mit einer dielektrischen Schicht in Kontakt mit der genannten ersten organischen Schicht (11) und Injektionselektroden in Kontakt mit der genannten zweiten organischen Schicht (13) aufweist; und
c) es begünstigt den Volumentransport der Minoritätsladungsträger im Vergleich zu den Majoritätsladungsträgern von der genannten ersten Injektionselektrode (16A) zu der Grenzfläche mit der genannten emittierenden organischen Schicht (12) durch eine Volumenbeweglichkeit der Minoritätsladungsträger, die zumindest eine Größenordnung grösser ist als die Volumenbeweglichkeit der Majoritätsladungsträger, wobei die genannte Grenzfläche von der genannten ersten Injektionselektrode (16A) um einen Abstand von mindestens 10 nm getrennt ist.

2. Die Mehrschichtstruktur (1) eines OLET-Transistors gemäß Anspruch 1, **dadurch gekennzeichnet, dass** die genannte emittierende organische Schicht (12) durch ein System vom Host-Guest-Typ mit Triplett-Emission gebildet wird.

3. Die Mehrschichtstruktur (1) eines OLET-Transistors nach einem beliebigen der vorhergehenden Ansprüche, **dadurch gekennzeichnet, dass** die genannte emittierende organische Schicht (12) aus einem Gemisch mehrerer Materialien besteht.

4. Die Mehrschichtstruktur (1) eines OLET-Transistors nach einem beliebigen der vorhergehenden Ansprüche, **dadurch gekennzeichnet, dass** die genannte emittierende organische Schicht (12) einen Stapel aus zwei oder mehr Lagen umfasst, wobei mindestens eine dieser Lagen optional aus einem Gemisch mehrerer Materialien besteht.

5. Die Mehrschichtstruktur (1) eines OLET-Transistors nach einem beliebigen der vorhergehenden Ansprüche, **dadurch gekennzeichnet, dass** die genannte dielektrische Schicht (14) den Durchtritt von Strom durch sie hindurch um einen Faktor von mindestens 10³, vorzugsweise um einen Faktor grösser oder gleich 10⁵, in Bezug auf den Stromdurchtritt zwischen den Injektionselektroden (16A, 16B) verhindert.

6. Elementaremittierende Einheit oder Subpixel (20), **dadurch gekennzeichnet, dass** sie als emittierendes Element einen OLET-Transistor aufweist, der mittels einer Mehrschichtstruktur (1) nach einem beliebigen der vorhergehenden Ansprüche realisiert ist.

7. Elementaremittierende Einheit oder Subpixel (20) nach Anspruch 6,
**dadurch gekennzeichnet, dass** der genannte OLET-Transistor über seine Injektionselektroden (16A, 16B) zwischen einer ersten Versorgungsspannungsreferenz (VDD) und einer zweiten Massespannungsreferenz (GND) angeschlossen ist, und ferner mindestens einen Adressier- und Steuertransistor aufweist, bei dem mindestens eine der Injektionselektroden mit einer Steuerelektrode (EG1) des genannten OLET-Transistors verbunden ist und eine Steuerelektrode mit einer ersten Auswahlleitung (Select Line 1) verbunden ist.

8. Elementaremittierende Einheit oder Subpixel (20) nach Anspruch 7, **dadurch gekennzeichnet, dass** der genannte Adressier- und Steuertransistor (OTFT1) über seine Injektionselektroden zwischen dem genannten Steueranschluss (EG1) des genannten OLET-Transistors und einer Datenleitung (Data Line) angeordnet ist.

9. Elementaremittierende Einheit oder Subpixel (20) nach Anspruch 8, **dadurch gekennzeichnet, dass** sie bzw. es ferner mit einem Transistor (OTFTc) verbunden ist, der einer ganzen Zeile oder Spalte von elementaremittierenden Einheiten oder Subpixeln (20) gemeinsam ist, der mit seinen Injektionselektroden zwischen einer Datenspannungsreferenz (VDATA) und der genannten Datenleitung (Data Line) jeder elementaremittierenden Einheit oder jedes Subpixels (20) angeordnet ist und einen Gate-Anschluss (G2) aufweist, der mit einer zweiten Auswahlleitung (Select Line 2) verbunden ist.

10. Elementaremittierende Einheit oder Subpixel (20) nach Anspruch 7, **dadurch gekennzeichnet, dass** sie bzw. es einen ersten und einen zweiten Adressier- und Steuertransistor (OTFT1, OTFT2) aufweist, welche jeweils miteinander elektrisch über eine der Injektionselektroden in einem gemeinsamen Anschluss (Xc) verbunden sind, wobei der genannte erste Adressier-und Steuertransistor (OTFT1) zwischen der genannte Datenleitung (Data Line) und dem gemeinsamen Anschluss (Xc) angeordnet ist und eine Steuerelektrode (G1) hat, die mit einer ersten Auswahlleitung (Select Line 1) verbunden ist, während der genannte zweite Adressier-und Steuertransistor (OTFT2) zwischen der genannten Gate-Elektrode (EG1) des genannten OLET-Transistors und dem genannten gemeinsamen Anschluss (Xc) angeordnet ist und eine Steuerelektrode (G2) aufweist, die mit einer zweiten Auswahlleitung (Select Line 2) verbunden ist.

11. Elementaremittierende Einheit oder Subpixel (20) nach einem der Ansprüche 6 bis 10, **dadurch gekennzeichnet, dass** der genannte OLET-Transistor einen integrierten intrinsischen Kondensator aufweist, der, als Platten, eine der genannten Injektionselektroden (16A, 16B) und die genannte Steuerelektrode (EG 1) hat und, als Isolierbereich, einen Abschnitt einer dielektrischen Schicht (14) hat, die die genannte Steuerelektrode (EG1) von einem organischen aktiven Bereich (10) trennt, wobei dieser intrinsische Kondensator in der Lage ist, einen Status des Pixels, das durch den OLET-Transistor realisiert wird, zu speichern.

12. Anzeigeeinheit mit einer Matrixanordnung (n, m) von elementaremittierenden Einheiten nach einem beliebigen der Ansprüche 6 bis 11.

## Revendications

1. Une structure multicouche (1) d'un transistor OLET réalisée sur au moins un substrat, comprenant au moins une couche organique émissive (12) et pourvue d'une première et d'une deuxième électrode d'injection (16A, 16B) et d'une électrode de commande (15), comprenant au moins une zone active organique (10) composée d'une séquence de trois couches organiques :
- une première couche organique (11) ayant des propriétés de transport à effet de champ ;
- ladite couche organique émissive (12), et
- une deuxième couche organique (13) ayant pour fonction de bloquer les porteurs de charges majoritaires de ladite première couche organique (11), ladite couche organique émissive (12) étant prise en sandwich entre lesdites première et deuxième couches organiques (11, 13), ainsi que
au moins une couche diélectrique (14) qui sépare ladite électrode de commande (15) de ladite zone active organique (10) et est en contact avec ladite première couche organique (11), ladite première électrode d'injection (16A) étant en contact avec ladite deuxième couche organique (13),
ladite deuxième couche organique (13) étant faite d'un matériau organique ayant les caractéristiques suivantes :
a) il a une distribution d'énergie par rapport à ladite couche organique émissive (12) apte à bloquer la diffusion des porteurs de charges majoritaires de ladite première couche organique (11), en générant, à l'interface entre ladite couche organique émissive (12) et ladite deuxième couche organique (13), une barrière d'énergie pendant le passage depuis ladite couche organique émissive (12) vers ladite deuxième couche organique (13) supérieure ou égale à 0,1 eV pour les porteurs de charge majoritaires, l'expression "barrière d'énergie" s'entendant comme signifiant la valeur absolue de la différence entre les niveaux LUMO (Lowest Occupied Molecular Orbital) ou les niveaux HOMO (Highest Occupied Molecular Orbital) des matériaux à ladite interface ;
lesdits matériaux organiques qui forment ladite première couche organique (11), ladite couche organique émissive (12) et ladite deuxième couche organique (13) forment des barrières d'énergie à leurs interfaces choisies comme suit :
- une barrière d'énergie à l'interface entre ladite première couche organique (11) et ladite couche organique émissive (12) inférieure ou égale à 0,6 eV pour les porteurs de charge majoritaires ;
- une barrière d'énergie pendant le passage depuis ladite couche organique émissive (12) vers ladite première couche organique (11) égale ou supérieure à 0 eV pour les porteurs de charge minoritaires ; et
- une barrière d'énergie pendant le passage depuis ladite deuxième couche organique (13) vers ladite couche organique émissive (12) inférieure ou égale à 1,5 eV pour les porteurs de charge minoritaires ;
b) il a une mobilité de charge qui est inférieure d'au moins deux ordres de grandeur à celle des porteurs de charge majoritaires de ladite première couche organique (11), la mobilité de ladite première couche organique (11) étant mesurée sur un transistor OTFT basé uniquement sur ladite première couche organique (11), tandis que la mobilité de ladite deuxième couche organique (13) est mesurée pour les porteurs de charge majoritaires sur un transistor OTFT basé uniquement sur ladite matière organique formant ladite deuxième couche organique (13) et pour les porteurs de charge minoritaires sur un transistor OTFT comprenant la configuration à trois couches de ladite zone active organique (10) ayant une couche diélectrique en contact avec ladite première couche organique (11) et des électrodes d'injection en contact avec ladite deuxième couche organique (13) ; et
c) il favorise le transport en vrac des porteurs de charges minoritaires par rapport aux porteurs de charges majoritaires depuis ladite première électrode d'injection (16A) vers l'interface avec ladite couche organique émissive (12) en ayant une mobilité volumique des porteurs minoritaires supérieure d'au moins un ordre de grandeur à la mobilité volumique des porteurs majoritaires, ladite interface étant séparée de ladite première électrode d'injection (16A) d'une distance d'au moins 10 nm.

2. La structure multicouche (1) d'un transistor OLET selon la revendication 1, **caractérisée en ce que** ladite couche organique émissive (12) est formée par un système du type hôte-invité avec émission triplet.

3. La structure multicouche (1) d'un transistor OLET selon l'une quelconque des revendications précédentes, **caractérisée en ce que** ladite couche organique émissive (12) est constituée d'un mélange de plusieurs matériaux.

4. La structure multicouche (1) d'un transistor OLET selon l'une quelconque des revendications précédentes, **caractérisée en ce que** ladite couche organique émissive (12) comprend un empilement de deux couches ou plus, l'une au moins desdites couches étant optionnellement réalisée en un mélange de plusieurs matériaux.

5. La structure multicouche (1) d'un transistor OLET selon l'une quelconque des revendications précédentes, **caractérisée en ce que** ladite couche diélectrique (14) empêche le passage du courant à travers elle pour une valeur d'au moins 10³ fois, de préférence pour une valeur supérieur ou égale à 10⁵, par rapport au passage du courant entre les électrodes d'injection (16A, 16B).

6. Unité émissive ou sous-pixel (20) élémentaire, **caractérisée en ce qu'**elle comprend, en tant qu'élément émissif, un transistor OLET réalisé au moyen d'une structure multicouche (1) selon l'une quelconque des revendications précédentes.

7. Unité émissive ou sous-pixel (20) élémentaire selon la revendication 6, **caractérisé en ce que** ledit transistor OLET est relié via ses électrodes d'injection (16A, 16B), entre une première référence de tension d'alimentation (VDD) et une deuxième référence de tension de masse (GND) et **en ce qu'**elle comprend en outre au moins un transistor d'adressage et de commande ayant au moins l'une des électrodes d'injection reliées à une électrode de commande (EG1) dudit transistor OLET et une électrode de commande reliée à une première ligne de sélection (Select Line 1).

8. Unité émissive ou sous-pixel (20) élémentaire selon la revendication 7, **caractérisée en ce que** ledit transistor d'adressage et de commande (OTFT1) est relié via ses électrodes d'injection, entre ladite borne de commande (EG1) dudit transistor OLET et une ligne de données (Data Line).

9. Unité émissive ou sous-pixel (20) élémentaire selon la revendication 8, **caractérisée en ce qu'**elle est en outre connectée à un transistor (OTFTc) commun à toute une rangée ou colonne d'unités émissives ou sous-pixels (20) élémentaires, relié au moyen de ses électrodes d'injection entre une référence de tension de données (VDATA) et ladite ligne de données (Data Line) de chaque unité émissive ou sous-pixel (20) élémentaire et ayant une borne de grille (G2) connectée à une deuxième ligne de sélection (Select Line 2).

10. Unité émissive ou sous-pixel (20) élémentaire selon la revendication 7, **caractérisée en ce qu'**elle comprend des premier et deuxième transistors d'adressage et de commande (OTFT1, OTFT2) respectivement reliés électriquement l'un à l'autre par l'une des électrodes d'injection dans une borne commune (Xc), ledit premier transistor d'adressage et de commande (OTFT1) étant relié entre ladite ligne de données (Data Line) et ladite borne commune (Xc) et ayant une électrode de commande (G1) connectée à une première ligne de sélection (Select Line 1), tandis que ledit deuxième transistor d'adressage et de commande (OTFT2) est relié entre ladite électrode de grille (EG1) dudit transistor OLET et ladite borne commune (Xc) et possède une électrode de commande (G2) reliée à une deuxième ligne de sélection (Select Line 2).

11. Unité émissive ou sous-pixel (20) élémentaire selon l'une quelconque des revendications 6 à 10, **caractérisée en ce que** ledit transistor OLET comprend un condensateur intrinsèque intégré comportant, en tant que plaques, une desdites électrodes d'injection (16A, 16B) et ladite électrode de commande (EG1) et, en tant que zone isolante, une partie d'une couche diélectrique (14) qui sépare ladite électrode de commande (EG1) d'une zone active organique (10), ce condensateur intrinsèque étant apte à stocker un état dudit pixel réalisé par ledit transistor OLET.

12. Afficheur comportant une configuration matricielle (n, m) d'unités émissives élémentaires selon l'une quelconque des revendications 6 à 11.
